# EUROPEAN PATENT APPLICATION

(11) **EP 4 394 771 A1**
(43) Date of publication of application: **03.07.2024**
(21) Application number: 22860607.5
(22) Date of filing: 25.08.2022
(51) Int. Cl.: G11C 5/02, G11C 7/12

(54) **FLASH MEMORY ARRAY, AND WRITE METHOD AND ERASURE METHOD THEREFOR**

(30) Priority: 26.08.2021 CN 202110989487; 26.08.2021 CN 202110988661; 26.08.2021 CN 202110987921
(71) Applicant: Beijing Panxin Microelectronics Technology Co., Ltd., Beijing 100191 (CN)
(72) Inventor: JIANG, Jiayong, Beijing 100191 (CN); SHI, Zhendong, Beijing 100191 (CN)
(74) Representative: Hoffmann Eitle
(86) International application number: PCT/CN2022/114959
(87) International publication number: WO 2023/025261

(57) **Abstract**

Provided in the present disclosure are a flash memory array, and a write method and erasure method therefor. The flash memory array according to the present disclosure comprises : a plurality of flash memory cells, which are arranged in a row direction and a column direction perpendicular to the row direction; a plurality of word line groups, which extend in the row direction; and a plurality of bit line groups, which extend in the column direction, wherein flash memory cell pairs are arranged at intersection points of the word line groups and the bit line groups, and the flash memory cell pair comprises a first flash memory cell and a second flash memory cell, which are adjacent in the row direction and share the same bit line group. By means of the flash memory array according to the present disclosure, the arrangement density of bit lines can be improved while the size of the array is not increased, and the bit line parasitic resistance can be reduced. In addition, compared with a flash memory array in the prior art, the flash memory array according to the present disclosure also has a better process compatibility and scaling characteristic. The write method for a flash memory array of the present disclosure has the advantages of a low operation power consumption and a fast programming speed, which is conducive to improving the number of concurrently written flash memory cells, thereby increasing the data writing throughput rate of a memory. The erasure method for a flash memory array of the present disclosure can improve a threshold voltage window and enhance the storage reliability, and also has the advantages of a low operation power consumption and a fast erasure speed.

## Description

### FIELD OF THE INVENTION

The present disclosure relates to the field of semiconductor technology, in particular, relates to a flash memory array as well as a writing method and an erasing method of the flash memory array.

### BACKGROUND OF THE INVENTION

A flash memory is a non-volatile memory, that is, the data stored therein can not be lost under the condition of power-off. It is especially applicable to the fields of mobile communication and computer storage component, etc. Besides, some flash memories also possess high-density storage capacity, so that it is applicable to large-capacity removable storage medium, etc.

The conventional flash memory adopts a floating gate type cell structure. The floating gate type non-volatile memory is originated from the MIMIS (Metal-Insulator-Metal-Semiconductor) structure proposed by D.kahng and S.Sze in 1967. This structure adds a metal floating gate and an ultra-thin tunneling oxide layer on basis of the conventional MOSFET (Metal-Oxide-Semiconductor Field Effect Transistor) to store charges using the metal floating gate. Based on this, a concept of flash memory was first proposed by Masuoka et al. in 1984, which can achieve a high-speed erasing capability by section-wise erasing and bit-wise writing and eliminate the selection transistor required in the EEPROM (Erasable Programmable Read-Only Memory), so that the storage cell has a smaller size. Thereafter, the flash memory is quickly developed due to its high writing speed, high integration level and excellent performance. A flash memory cell with an ETOX (Electron Tunneling Oxide) structure was proposed by Intel Corp. in 1988, which becomes the basis of developing most floating gate type flash memory cell structures.

However, the floating gate type flash memory has the following disadvantages: the process is complicated; due to the floating gate structure in the flash memory cell, the vertical height of the gate structure is increased, which is not conducive to scaling down the process size and the cell area; at the same time, due to the conductivity of the floating gate, the stored charges can move freely in the floating gate, so that it is not conducive to raising the reliability of memory. To solve the problems of complex process and poor reliability of floating gate type flash memory, researchers have proposed a charge trap memory (CTM: Charge-Trapping-Memory), also referred to as SONOS (Silicon-Oxide-Nitride-Oxide-Silicon) flash memory. Based on this, a two-bit memory cell structure NROM (Nitride-Read-Only-Memory) was proposed by B. Eitan et al. in 2000. This cell structure utilizes the non-conductive property of insulating silicon nitride storage dielectric to respectively implement two storage bits at the source terminal and drain terminal of a storage transistor. However, this cell structure has the disadvantages that the two storage bits are mutually interfered, and its device size cannot be scaled down, etc.

However, the existing floating gate type ETOX flash memory and SONOS type NROM flash memory all have the problems of failure of process size scaling down, large cell area, large writing power consumption and large array area overhead, and can not realize high-density integration above Gb capacity.

In addition, the existing flash memory array needs to set bit lines, word lines and source lines to implement the selection and operation of flash memory cells. However, the source lines of the existing flash memory array are formed in the active region, and the square resistance of the active region is far higher than that of metal. Therefore, in order to reduce the series resistance of the source lines, it is necessary to short-circuit the source lines of the active region together by means of metal common source lines at intervals of several rows or columns in the row direction or column direction, resulting in increased area overhead of the flash memory array.

With the rapid development of applications such as mobile smart terminals, wearable devices, smart sensor networks and the like, higher requirements are put forward for power consumption, storage capacity, and cost of the flash memory. Therefore, a flash memory technology with the advantages of low power consumption, small cell area, scalable process size, high array integration density, large capacity and the like is required.

### SUMMARY OF THE INVENTION

The above information disclosed in the section "BACKGROUND OF THE INVENTION" is only used for the purpose of understanding the background of the inventive concept and therefore may contain information that does not constitute the prior art.

In order to solve the above problems existing in the prior art, the present disclosure proposes a flash memory array as well as a writing method and an erasing method of the flash memory array.

According to an aspect of the present disclosure, there is provided a flash memory array comprising: a plurality of flash memory cells arranged in a row direction and a column direction perpendicular to the row direction; a plurality of word line sets extending in the row direction; and a plurality of bit line sets extending in the column direction, wherein a flash memory cell pair is disposed at an intersection of the word line set and the bit line set, and the flash memory cell pair includes a first flash memory cell and a second flash memory cell adjacent in the row direction and sharing the same bit line set.

The flash memory array according to the present disclosure may improve the arrangement density of the bit lines and may reduce the parasitic resistance of the bit lines without increasing the size of the array. In addition, compared with the flash memory array of the prior art, the flash memory array according to the present disclosure also has better process compatibility and scaling down characteristics.

According to another aspect of the present disclosure, there is provided a writing method of the flash memory array according to the above aspect, comprising: performing a write operation on the first storage transistor of the first flash memory cell by applying a first writing voltage to the first bit line, applying a second writing voltage to the middle bit line and the second bit line, applying a third writing voltage to the first control line, applying a fourth writing voltage to the word line, and applying a fifth writing voltage to the second control line; performing a write operation on the second storage transistor of the first flash memory cell by applying the second writing voltage to the first bit line, applying the first writing voltage to the middle bit line and the second bit line, applying the fifth writing voltage to the first control line, applying the fourth writing voltage to the word line, and applying the third writing voltage to the second control line; performing a write operation on the first storage transistor of the second flash memory cell by applying the first writing voltage to the first bit line and the middle bit line, applying the second writing voltage to the second bit line, applying the third writing voltage to the first control line, applying the fourth writing voltage to the word line, and applying the fifth writing voltage to the second control line; and performing a write operation on the second storage transistor of the second flash memory cell by applying the second writing voltage to the first bit line and the middle bit line, applying the first writing voltage to the second bit line, applying the fifth writing voltage to the first control line, applying the fourth writing voltage to the word line, and applying the third writing voltage to the second control line. The fourth writing voltage is equal to or lower than a first power voltage, the second writing voltage is equal to or higher than a second power voltage, the first writing voltage is higher than a preset voltage, and the third writing voltage is higher than the first writing voltage. The first power voltage is higher than the second power voltage. The preset voltage is predetermined based on a carrier barrier height at an interface between a substrate and gate dielectric stacks of the first storage transistor and the second storage transistor. The first writing voltage, the fourth writing voltage, and the fifth writing voltage are higher than the second writing voltage. The second writing voltage is connected to the second power voltage through a constant current load. During a writing operation of a flash memory cell, the first writing voltage, the second writing voltage, the third writing voltage, the fourth writing voltage, and the fifth writing voltage turn on all the first storage transistor, the second storage transistor, and the selection transistor of the flash memory cell.

According to the writing method of the flash memory array of the present disclosure, in a selected column of flash memory cells, only at most two bit lines need to be charged to a high writing voltage, so that the power consumption caused by charging the parasitic capacitance of the bit lines is greatly reduced, and thus the advantage of low power consumption may be achieved compared with the existing writing method of the flash memory array. In addition, the advantage of low power consumption of the writing method of the flash memory array of the present disclosure is beneficial to increasing the number of the flash memory cells written in parallel, thereby increasing the data writing throughput of the flash memory array and overcoming the defect of slow data writing of the existing NOR type flash memory.

According to yet another aspect of the present disclosure, there is provided an erasing method of the flash memory array according to the above aspect, comprising a first erasing step of: performing an erasing operation on the first storage transistors of the first flash memory cell and the second flash memory cell by applying a first erasing voltage to the first bit line, the middle bit line, and the second bit line, applying a second erasing voltage to the first control line, and applying a second power voltage to the word line and the second control line or floating the word line and the second control line; and performing an erasing operation on the second storage transistors of the first flash memory cell and the second flash memory cell by applying the first erasing voltage to the first bit line, the middle bit line, and the second bit line, applying the second power voltage to the word line and the first control line or floating the word line and the first control line, and applying the second erasing voltage to the second control line. The first erasing voltage is higher than a preset voltage, and the second erasing voltage is equal to or lower than the second power voltage. The preset voltage is predetermined based on a carrier barrier height at an interface between a substrate and gate dielectric stacks of the first storage transistor and the second storage transistor.

According to the erasing method of the flash memory array of the present disclosure, the threshold voltage window of the erasing operation and the storage reliability may be improved, while the advantages of low operation power consumption and fast erasing speed may be achieved.

However, the effects of the present disclosure are not limited to the above-described effects, and various extensions can be made without departing from the spirit and scope of the present disclosure. It should be understood that both the aforementioned general description and the following detailed description are exemplary and illustrative, and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate exemplary embodiments of the invention and together with the description serve to explain the concept of the invention.
FIG. 1 illustrates a cross-sectional view of a flash memory cell according to an embodiment of the present disclosure.
FIG. 2 illustrates an equivalent circuit diagram of the flash memory cell according to an embodiment of the present disclosure.
FIG. 3 illustrates a circuit schematic diagram of a flash memory cell pair according to a first embodiment of the present disclosure.
FIG. 4 illustrates a circuit schematic diagram of a flash memory array according to the first embodiment of the present disclosure.
FIG. 5 illustrates a schematic diagram of a layout example of a bit line set according to the first embodiment of the present disclosure.
FIG. 6 illustrates a schematic diagram of another layout example of a bit line set according to the first embodiment of the present disclosure.
FIG. 7 illustrates a circuit schematic diagram of a flash memory cell pair according to a second embodiment of the present disclosure.
FIG. 8 illustrates a circuit schematic diagram of a flash memory array according to the second embodiment of the present disclosure.
FIG. 9 illustrates a schematic diagram of a layout example of a bit line set according to the second embodiment of the present disclosure.
FIG. 10 illustrates a schematic diagram of a layout of control lines of a flash memory array according to an embodiment of the present disclosure.
FIG. 11 illustrates an equivalent circuit diagram for performing a write operation on the first storage transistor in the flash memory cell according to an embodiment of the present disclosure.
FIG. 12 illustrates a schematic diagram of performing a write operation on the first storage transistor of the first flash memory cell according to an embodiment of the present disclosure.
FIG. 13 illustrates a schematic diagram of performing a write operation on the second storage transistor of the first flash memory cell according to an embodiment of the present disclosure.
FIG. 14 illustrates a schematic diagram of performing a write operation on the first storage transistor of the second flash memory cell according to an embodiment of the present disclosure.
FIG. 15 illustrates a schematic diagram of performing a write operation on the second storage transistor of the second flash memory cell according to an embodiment of the present disclosure.
FIG. 16 illustrates a conceptual schematic diagram of performing an erasing operation on the first storage transistor by a first erasing step according to an embodiment of the present disclosure.
FIG. 17 illustrates a conceptual schematic diagram of simultaneously performing an erasing operation on the first storage transistor and the second storage transistor by a second erasing step according to an embodiment of the present disclosure.
FIG. 18 illustrates a conceptual schematic diagram of performing an erasing operation on the first storage transistor and the second storage transistor by a third erasing step according to an embodiment of the present disclosure.
FIG. 19 illustrates a schematic diagram of performing an erasing operation on the first storage transistors of the first flash memory cell and the second flash memory cell by the first erasing step according to an embodiment of the present disclosure.
FIG. 20 illustrates a schematic diagram of performing an erasing operation on the second storage transistor of the first flash memory cell and the second flash memory cell by the first erasing step according to an embodiment of the present disclosure.
FIG. 21 illustrates a schematic diagram of performing an erasing operation on the first flash memory cell and the second flash memory cell by the second erasing step according to an embodiment of the present disclosure.
FIG. 22 illustrates a schematic diagram of performing an erasing operation on the first flash memory cell and the second flash memory cell by the third erasing step according to an embodiment of the present disclosure.
FIG. 23 illustrates a flowchart of an erasing method of the flash memory array according to an embodiment of the present disclosure.

### EMBODIMENTS OF THE INVENTION

In the following description, for the purpose of explanation, many specific details are set forth in order to provide a thorough understanding of exemplary embodiments or implementations of the present invention. As used herein, "embodiment" and "implementation" are interchangeable words, and are non-limiting examples of the device or method employing one or more of the inventive concepts disclosed herein. However, it is obvious that the exemplary embodiments may be embodied without these specific details or with one or more equivalent arrangements. In other instances, well-known structures and devices are shown in block diagram in order to avoid unnecessarily obscuring the exemplary embodiments. In addition, the exemplary embodiments may be different, but need not be exclusive. For example, certain shapes, configurations, and characteristics of the exemplary embodiments may be used or implemented in other exemplary embodiments without departing from the spirit of the present invention.

Unless otherwise stated, the illustrated exemplary embodiments should be understood to provide exemplary features with varying details of some of the ways in which the inventive concepts may be practiced. Therefore, unless otherwise stated, features, components, modules, layers, films, panels, regions and/or aspects, etc. (hereinafter individually or collectively referred to as "elements") of various embodiments may be additionally combined, separated, interchanged and/or rearranged without departing from the concepts of the invention.

The cross-hatching and/or shading used in the drawings is generally provided for clarifying the boundaries between adjacent elements. Thus, unless otherwise stated, the presence or absence of cross-hatching or shading does not convey or indicate any preference or requirement for certain materials, material characteristics, sizes, proportions, commonalities among the illustrated elements, and/or any other characteristics, attributes, shapes, etc. of the elements. In addition, in the drawings, for clarity and/or descriptive purpose, sizes and relative sizes of elements may be exaggerated. While exemplary embodiments may be variously implemented, a particular process order may be performed differently from the described order. For example, two consecutively described processes may be performed substantially simultaneously or in a reverse order to the described order. Likewise, like reference numerals designate like elements.

When an element, such as a layer, is referred to as being "on", "connected to" or "coupled to" another element or layer, it may be directly on, directly connected to or coupled to another element or layer, or there may be an intervening element or layer. However, when an element or layer is referred to as being "directly on", "directly connected to" or "directly coupled to" another element or layer, no intervening element or layer is present. As such, the term "connection" may refer to physical, electrical and/or fluidic connection with or without an intervening element. In addition, a D1 axis, a D2 axis, and a D3 axis are not limited to three axes of a rectangular coordinate system, such as x, y and z axes, and may be interpreted in a broader sense. For example, the D1 axis, D2 axis, and D3 axis may be perpendicular to each other, or may represent different directions that are not perpendicular to each other. For the purposes of the present disclosure, "at least one of X, Y, and Z" and "at least one selected from the set consisting of X, Y, and Z" may be interpreted as X only, Y only, Z only, or any combination of two or more of X, Y, and Z, such as, for example, XYZ, XYY, YZ, and ZZ. As used herein, the term "and/or" includes any and all combinations of one or more of related items listed.

Although the terms "first," "second," etc. may be used herein to describe various types of elements, these elements should not be limited by these terms. These terms are used to distinguish one element from another. Thus, a first element discussed below could be referred to as a second element without departing from the teaching of the present disclosure.

Spatial relational terms, such as "below", "under", "lower", "above", "on", "upper" and "side" (for example, on a "sidewall "), etc., may be used herein for the descriptive purpose, so as to describe the relationship between one element and another element as shown in the drawings. The spatial relational terms are intended to encompass different orientations of a device in use, operation, and/or manufacture in addition to the orientation shown in the drawings. For example, if the device in the drawings is reversed, an element described as being "below" or "under" another element or feature will be oriented "above" the another elements or feature. Therefore, the exemplary term "below" may encompass orientations of both above and below. Furthermore, the device may be otherwise oriented (for example, rotated 90 degrees or at other orientations) and thus the spatial relationship descriptors used herein are interpreted accordingly.

The terminology used herein is for the purpose of describing particular embodiments, and not intended to be limiting. As used herein, the singular forms "a", "an" and "the" are intended to also include the plural form, unless the context clearly indicates otherwise. In addition, the terms "comprises" and/or "comprising" when used herein specify the presence of stated features, integers, steps, operations, elements, components, and/or sets thereof, but does not exclude the presence or addition of one or more other features, integers, steps, operations, elements, components, and/or sets thereof. As used herein, the terms "substantially", "about" and other similar terms are used as terms of approximation rather than terms of degree, and are thus utilized to account for inherent deviations in measured, calculated and/or provided values as appreciated by those skilled in the art.

As usual in the art, some exemplary embodiments are described and illustrated in the accompanying drawings in terms of functional blocks, cells and/or modules. It should be understood by those skilled in the art that these blocks, cells and/or modules are physically implemented by electronic (or optical) circuits, such as logic circuits, discrete components, microprocessors, hardwired circuits, memory elements, wiring connections, etc. They may be formed using semiconductor-based fabrication techniques or other fabrication techniques. When implemented by microprocessors or other similar hardware, the blocks, cells and/or modules may be written and controlled by using software (for example, microcode), to perform the various functions discussed herein, and may optionally be driven by firmware and/or software. It is also considered that each of the blocks, cells and/or modules may be implemented by dedicated hardware, or implemented as combination of dedicated hardware that performs some functions with a processor that performs other operations (for example, one or more written microprocessors and related circuits). Furthermore, each of blocks, cells, and/or modules of some exemplary embodiments may be physically divided into two or more interactive and discrete blocks, cells, and/or modules, without departing from the scope of the inventive concept. The blocks, cells and/or modules of some exemplary embodiments may be physically combined into more complex blocks, cells and/or modules without departing from the scope of the inventive concept.

Embodiments are described herein with reference to cross-sectional and/or exploded views which are schematic diagrams of idealized embodiments and/or intermediate structures. As such, variations from the shapes illustrated as a result, for example, of manufacturing techniques and/or tolerances, are to be expected, and thus the embodiments disclosed herein are not necessarily construed as limited to the particular illustrated shapes of regions, but are to include deviations in shapes that result, for example, from manufacturing. In this way, the regions illustrated in the drawings may be schematic in nature and the shapes of these regions may not reflect the actual shapes of the regions of the device, and thus are not necessarily intended to be limiting.

Unless otherwise defined, all terms (including technical terms and scientific terms) used herein have the same meaning as those commonly understood by those skilled in the art to which the present disclosure belongs. Terms, such as those defined in commonly used dictionaries, should be interpreted as having a meaning that is consistent with their meaning in the context of the relevant art and will not be interpreted in an idealized or overly formal sense unless expressly defined herein.

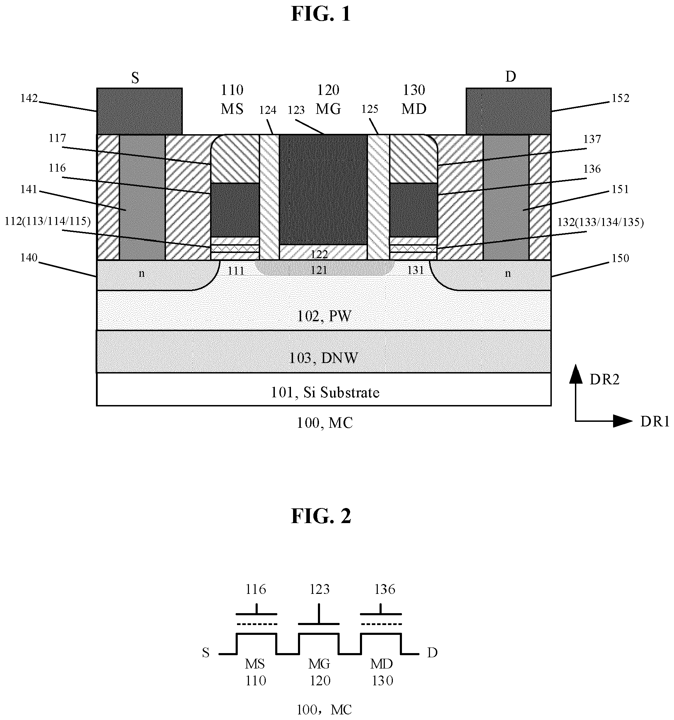

FIG. 1 illustrates a cross-sectional view of a flash memory cell MC 100 according to an embodiment of the present disclosure.

As shown in FIG. 1, the flash memory cell MC 100 according to an embodiment of the present disclosure may include a substrate 101 including a deep well region DNW 103 of a second doping type and a well region PW 102 of a first doping type disposed on the deep well region DNW 103.

Although the first doping type is defined as P-type and the second doping type is defined as N-type in FIG. 1 as an example, those skilled in the art should appreciate that the present disclosure is not limited thereto, and the first doping type may also be N-type, and thus the second doping type may be P-type.

According to an embodiment of the present disclosure, the substrate 101 may be, for example, a silicon (Si) substrate.

Further, the flash memory cell MC100 includes a first storage transistor MS 110, a selection transistor MG 120, and a second storage transistor MD 130 sequentially connected in series. The first storage transistor MS 110 may be disposed on the well region PW 102 and store first data DATA1. The second storage transistor MD 130 may be disposed on the well region PW 102 and store second data DATA2. The selection transistor MG 120 is disposed between the first storage transistor MS 110 and the second storage transistor MD 130 in a horizontal direction DR1 on the well region PW 102, to isolate the first storage transistor MS 110 and the second storage transistor MD 130 and to perform a selection operation on the first storage transistor MS 110 and the second storage transistor MD 130.

According to an embodiment of the present disclosure, the flash memory cell MC 100 includes two storage transistors MS 110 and MD 130, and thus the flash memory cell MC 100 can achieve a function of two-bit storage, that is, storing the first data DATA1 and the second data DATA2 at the same time.

In addition, as shown in FIG. 1, a source region of the first storage transistor MS 110 is connected to a first electrode S of the flash memory cell MC 100, which may also be referred to as a source S of the flash memory cell MC 100, while a drain region of the second storage transistor MD 130 is connected to a second electrode D of the flash memory cell MC 100, which may also be referred to as a drain D of the flash memory cell MC 100.

Those skilled in the art should appreciate that the source and drain of the flash memory cell are defined herein for facilitating description, however, the definitions of the source and drain of the flash memory cell are relative, and the terms "source" and "drain" are used interchangeably under different operating conditions.

In addition, as shown in FIG. 1, the first storage transistor MS 110 has a gate structure including a channel region 111, a gate dielectric stack 112, a gate electrode 116 and a hard mask blocking portion 117 sequentially disposed in a vertical direction DR2. The gate dielectric stack 112 has a first oxide layer 113, a storage dielectric layer 114 and a second oxide layer 115 sequentially stacked in the vertical direction DR2. The second storage transistor MD 130 has a gate structure including a channel region 131, a gate dielectric stack 132, a gate electrode 136 and a hard mask blocking portion 137 sequentially disposed in the vertical direction DR2. The gate dielectric stack 132 has a first oxide layer 133, a storage dielectric layer 134 and a second oxide layer 135 sequentially stacked in the vertical direction DR2.

According to an embodiment of the present disclosure, the flash memory cell MC 100 includes two storage transistors MS 110 and MD 130, and thus may implement the function of two-bit storage.

According to an embodiment of the present disclosure, as shown in FIG. 1, the flash memory cell MC 100 for two-bit storage may consist of three closely arranged transistors, that is, the selection transistor MG 120 located in the middle of the flash memory cell MC 100, the first storage transistor MS 110 located at the first end of the flash memory cell MC 100 and the second storage transistor MD 130 located at the second end of the flash memory cell MC 100.

As shown in FIG. 1, the flash memory cell MC 100 may be formed on the well region PW 102 within the semiconductor substrate 101. In addition, in order to isolate the well region PW 102 from the substrate 101 so as to apply a voltage to the well region PW 102 under certain operating conditions, the well region PW 102 may be formed in the deep well region DNW 103 as shown in FIG. 1.

As shown in FIG. 1, a source region 140 formed by N-type doping is disposed at the first end of the flash memory cell MC 100, and a drain region 150 formed by N-type doping is further disposed at the second end of the flash memory cell MC 100. The source region 140 is connected to a metal source 142, that is, the first electrode S, located in the upper layer through a contact hole 141, and the drain region 150 is connected to a metal drain 152, that is, the second electrode D, located in the upper layer through a contact hole 151.

According to an embodiment of the present disclosure, the first electrode S and the second electrode D may include a metal or highly doped polysilicon. When the first electrode S and the second electrode D are formed of a metal, they may include at least one of the following materials: aluminum, titanium, titanium nitride, copper, tungsten, cobalt, and manganese.

As described above, as shown in FIG. 1, the gate structure of the first storage transistor MS 110 may sequentially have the channel region 111, the gate dielectric stack 112, the gate electrode 116 and the hard mask blocking portion 117 for sidewall self-alignment from bottom to top. According to an embodiment of the present disclosure, the gate electrode 116 may include, for example, polysilicon, a metal gate, a metal silicide material, or a combination thereof. According to an embodiment of the present disclosure, the hard mask blocking portion 117 may include, for example, silicon oxide, silicon nitride, a silicon glass material, or a combination thereof.

In addition, as shown in FIG. 1, the gate dielectric stack 112 has the first oxide layer (tunneling oxide layer) 113, the storage dielectric layer (charge storage layer) 114 and the second oxide layer (blocking oxide layer) 115 sequentially stacked in the vertical direction. According to an embodiment of the present disclosure, the first oxide layer 113 and the second oxide layer 115 may include, for example, silicon oxide or aluminum oxide, etc.

According to an embodiment of the present disclosure, the storage dielectric layer 114 may include one or more storage dielectric layers. In addition, according to an embodiment of the present disclosure, the storage dielectric forming the storage dielectric layer 114 may include: mono-element or multi-element oxide, such as hafnium oxide, tantalum oxide, titanium oxide, zirconium oxide, hafnium aluminum oxide; mono-element or multi-element nitride, such as silicon nitride; mono-element or multi-element oxynitride, such as silicon oxynitride; a polysilicon or nano-crystal material; or combinations thereof.

According to an embodiment of the present disclosure, when the storage dielectric layer 114 is formed of, for example, a silicon nitride material, the first oxide layer 113, the storage dielectric layer 114 and the second oxide layer 115 may form the gate dielectric stack 112 as an ONO (oxide-nitride-oxide) composite storage dielectric. At this time, the first storage transistor MS 110 may be a SONOS type storage transistor.

Furthermore, according to an embodiment of the present disclosure, the first storage transistor MS 110 may be another trap charge trapping type storage transistor having a similar operating mechanism to the SONOS type storage transistor. This type of storage transistor uses a high K material containing rich charge traps such as silicon oxynitride, hafnium oxide, tantalum oxide, titanium oxide, zirconium oxide, hafnium aluminum oxide, etc. as the storage dielectric layer 114 instead of the silicon nitride material in the SONOS memory.

In addition, according to an embodiment of the present disclosure, the first storage transistor MS 110 may also be a floating gate type storage transistor, which adopts a polysilicon material instead of the silicon nitride material in the SONOS memory to form a floating gate for storing charges, as the storage dielectric layer 114.

In addition, according to an embodiment of the present disclosure, the first storage transistor MS 110 may also be a nano-crystal storage transistor, which adopts a nano-crystal material with quantum dots as the storage dielectric layer 114 instead of the silicon nitride material in the SONOS memory.

According to an embodiment of the present disclosure, the length of the gate electrode 116 of the first storage transistor MS 110 may be defined by the length of the hard mask blocking portion 117 disposed on the gate electrode 116 through a self-alignment process. It should be noted by those skilled in the art that the "length" referred to herein means the size of the stated object in the horizontal direction DR1.

According to an embodiment of the present disclosure, the second storage transistor MD 130 has the same structure as the first storage transistor MS 110 and may be manufactured by the same process as the first storage transistor MS 110 except being disposed at the opposite side of the selection transistor MG 120, and thus a detailed description of the structure of the second storage transistor MD 130 will be omitted here for brevity.

The gate structure of the selection transistor MG 120 may sequentially include a channel region 121, a gate dielectric layer 122 and a gate electrode 123 from bottom to top. According to an embodiment of the present disclosure, the gate electrode 123 of the selection transistor MG 120 is connected to a word line. The length of the gate electrode 123 is defined by the process size of the photolithography process. According to an embodiment of the present disclosure, the gate dielectric layer 122 may include a material such as silicon oxide, silicon oxynitride, hafnium oxide, etc. In addition, according to an embodiment of the present disclosure, the gate electrode 123 may include a material such as polysilicon, a metal gate, a metal silicide material, or a combination thereof.

According to an embodiment of the present disclosure, the channel regions 111, 131, and 121 of the first storage transistor MS 110, the second storage transistor MD 130, and the selection transistor MG 120 may each have a first doping type, and the doping concentration of the channel regions 111 and 131 of the first storage transistor MS 110 and the second storage transistor MD 130 may be lower than the doping concentration of the channel region 121 of the selection transistor MG 120.

In addition, according to an embodiment of the present disclosure, the channel regions 111 and 131 of the first storage transistor MS 110 and the second storage transistor MD 130 may have a second doping type or be undoped intrinsic channel regions, and the channel region 121 of the selection transistor MG 120 may have a first doping type different from the second doping type.

For example, as shown in FIG. 1, where the first doping type is P-type and the second doping type is N-type, the doping concentrations of the P-type channels 111 and 131 of the first storage transistor MS 110 and the second storage transistor MD 130 are lower than the doping concentration of the P-type channel 121 of the selection transistor MG 120. In addition, according to an embodiment of the present disclosure, the channel regions 111 and 131 may also be undoped intrinsic channels or N-type doped channel regions.

According to an embodiment of the present disclosure, the flash memory cell MC 100 further includes: a first isolation portion 124 disposed between the first storage transistor MS 110 and the selection transistor MG 120 in the horizontal direction DR1, for isolating the gate electrode 116 of the first storage transistor MS 110 and the gate electrode 123 of the selection transistor MG 120; and a second isolation portion 125 disposed between the selection transistor MG 120 and the second storage transistor MD 130 in the horizontal direction DR1, for isolating the gate electrode 123 of the selection transistor MG 120 and the gate electrode 136 of the second storage transistor MD 130.

Specifically, as shown in FIG. 1, both sides of the gate electrode 123 of the selection transistor MG 120 are provided with the first isolation portion 124 and the second isolation portion 125 in the form of sidewalls. They are respectively used to electrically isolate the gate electrode 116 of the first storage transistor MS 110 and the gate electrode 136 of the second storage transistor MD 130 with a specific isolation gap length. According to an embodiment of the present disclosure, the first isolation portion 124 and the second isolation portion 125 may include the same material as the gate dielectric layer 122.

The flash memory cell according to an embodiment of the present disclosure can implement two storage transistors in one flash memory cell, thus the equivalent area of each storage bit may be greatly reduced, whereby a lower cost and a higher integration density are obtained.

In addition, the storage transistors in the flash memory cell according to an embodiment of the present disclosure can adopt the SONOS type device structure with a simple structure, with the advantages of a simple process, a low gate electrode operation voltage, and a good data retention reliability.

In addition, mutual influence of two storage bits is isolated by the selection transistor in the flash memory cell according to an embodiment of the present disclosure. In addition, the distribution width and transverse diffusion of the stored charges are suppressed, so that a higher stored charge density can be obtained in the silicon nitride storage layer, the problems of wide charge distribution, large mutual interference, failure of reducing gate length and the like existing in the conventional NROM storage cell with two storage bits are avoided, and the storage window and the data reliability are obviously improved.

In particular, the equivalent channel length of the flash memory cell according to an embodiment of the present disclosure is the sum of the lengths of the gate electrodes of the first storage transistor, the selection transistor and the second storage transistor. As described above, the length of the gate electrode of the selection transistor is defined by the process feature size of the photolithography process, usually approximately equal to or slightly larger than the critical feature size of the photolithography process, which is commonly denoted by F (or CF). Furthermore, the lengths of the gate electrodes of the first storage transistor and the second storage transistor are respectively defined by the lengths of the self-aligned sidewall hard mask blocking portions, and therefore, the size thereof may be smaller than F. Therefore, according to an embodiment of the present invention, a smaller channel length of the flash memory cell may be obtained under the same process feature size, thereby achieving the purpose of reducing the area and the manufacturing cost of the flash memory cell.

In addition, in a flash memory array composed of the flash memory cells according to an embodiment of the present disclosure, for the flash memory cells that are not selected for operation, the gate electrodes of the selection transistor and the first and second storage transistors are connected to the ground, whereby the entire series channel of the flash memory cell is completely turned off, and the equivalent channel length is enlarged, and therefore, the source-drain punch-through of the flash memory cell at a high operating voltage may be avoided under a smaller process feature size. Therefore, the problem that the length of the gate electrode of the existing flash memory cell cannot be reduced along with the scaling down of the process characteristic size is overcome. Therefore, the flash memory cell according to an embodiment of the present disclosure has better process scaling down capability, whereby a smaller cell area and manufacturing cost can be obtained by reducing the process feature size.

Further, in the flash memory cell according to an embodiment of the present disclosure, the threshold voltage of the storage transistors and the gate electrode operation voltage at the time of erasing, writing and reading operations may decrease by decreasing the doping concentration of the P-type channel regions of the first storage transistor and the second storage transistor or designing them into N-type doped channel regions, whereby the reliability of the storage transistors may be improved. Meanwhile, the punch-through resistance voltage of the flash memory cell may be improved and the leakage current between the source region and the drain region of the non-selected flash memory cell may be reduced by increasing the doping concentration of the P-type channel region of the selection transistor.

FIG. 2 illustrates an equivalent circuit of the flash memory cell MC 100 according to an embodiment of the present disclosure.

Specifically, as shown in FIG. 2, the flash memory cell MC 100 includes the first storage transistor MS 110, the selection transistor MG 120, and the second storage transistor MD 130 sequentially connected in series. The selection transistor MG 120 may isolate the first storage transistor MS 110 and the second storage transistor MD 130 and perform a selection operation on the first storage transistor MS 110 and the second storage transistor MD 130.

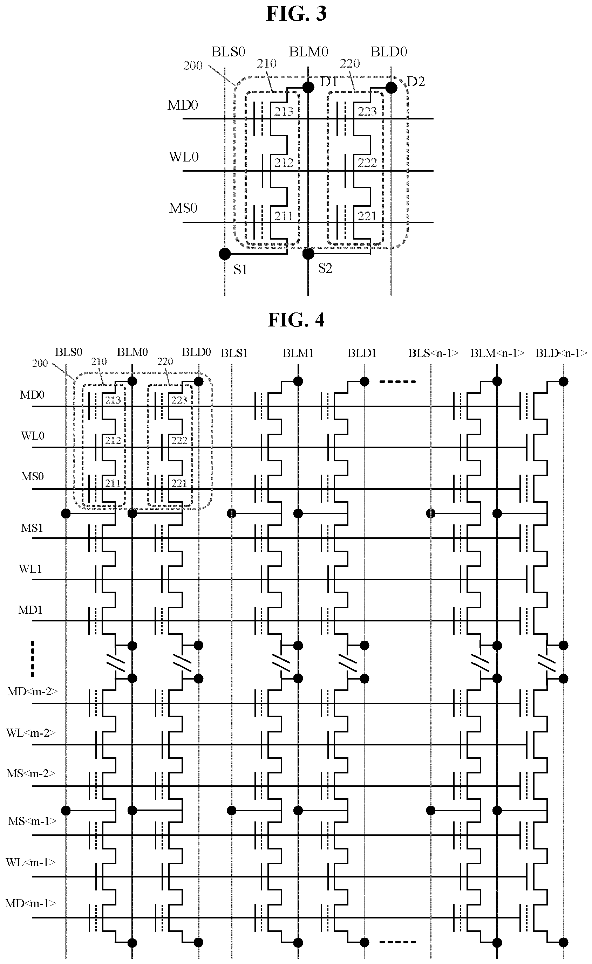

FIG. 3 illustrates a circuit schematic diagram of a flash memory cell pair 200 according to a first embodiment of the present disclosure. FIG. 4 illustrates a circuit schematic diagram of a flash memory array according to the first embodiment of the present disclosure.

According to an embodiment of the present disclosure, the flash memory array may include: a plurality of flash memory cells arranged in a row direction and a column direction perpendicular to the row direction; a plurality of word line sets extending in the row direction; and a plurality of bit line sets extending in the column direction, wherein a flash memory cell pair is disposed at an intersection of the word line set and the bit line set, and the flash memory cell pair includes a first flash memory cell and a second flash memory cell adjacent in the row direction and sharing the same bit line set.

As shown in FIGS. 3 and 4, according to an embodiment of the present disclosure, a flash memory array may include a plurality of flash memory cells as shown in FIG. 2, which may be arranged in an m × 2n array in the row direction and the column direction perpendicular to the row direction, where m and n are natural numbers greater than 1. Therefore, the plurality of flash memory cells form the flash memory array of m rows by 2n columns.

As shown in FIG. 3, according to an embodiment of the present disclosure, two flash memory cells adjacent in the row direction may constitute one flash memory cell pair 200, which includes a first flash memory cell 210 and a second flash memory cell 220. For example, the first flash memory cells 210 may be the flash memory cell located in the Oth row and the Oth column in the flash memory array, while the second flash memory cells 220 may be the flash memory cell located in the Oth row and the 1st column in the flash memory array. Therefore, according to an embodiment of the present disclosure, the flash memory array may include flash memory cell pairs arranged in m rows by n columns.

The first flash memory cell 210 includes a first storage transistor 211, a selection transistor 212, and a second storage transistor 213 sequentially connected in series in the column direction. The second flash memory cell 220 includes a first storage transistor 221, a selection transistor 222, and a second storage transistor 223 sequentially connected in series in the column direction.

According to an embodiment of the present disclosure, in the first flash memory cell 210, the source region of the first storage transistor 211 is connected to the first electrode S1 of the first flash memory cell 210, and the drain region of the second storage transistor 213 is connected to the second electrode D1 of the first flash memory cell 210.

In addition, according to an embodiment of the present disclosure, in the second flash memory cell 220, the source region of the first storage transistor 221 is connected to the first electrode S2 of the second flash memory cell 220, and the drain region of the second storage transistor 223 is connected to the second electrode D2 of the second flash memory cell 220.

In addition, according to an embodiment of the present disclosure, the flash memory cell pair 200, that is, the pair of the first flash memory cell 210 and the second flash memory cell 220, share a bit line set extending in the column direction, which includes a first bit line BSL0, a middle bit line BLMO, and a second bit line BLD0. According to the first embodiment of the present disclosure, the first bit line BSL0 may be connected to the first electrode S1 of the first flash memory cell 210, the second bit line BLD0 may be connected to the second electrode D2 of the second flash memory cell 220, and the middle bit line BLM0 may connect the second electrode D1 of the first flash memory cell 210 and the first electrode S2 of the second flash memory cell 220.

As described above, according to an embodiment of the present disclosure, the first flash memory cell 210 and the second flash memory cell 220 adjacent in the row direction are connected to the same first bit line BSL0, the middle bit line BLM0 and the second bit line BLD0. That is, according to an embodiment of the present disclosure, in the flash memory array, the flash memory cell pair shares the same bit line set. For example, the Oth column of flash memory cells and the 1st column of flash memory cells share the bit line set including the first bit line BLSO, the middle bit line BLM0 and the second bit line BLDO, the 2nd column of flash memory cells and the 3rd column of flash memory cells share a bit line set including a first bit line BLS1, a middle bit line BLM1 and a second bit line BLD1, until that the 2n-2nd column of flash memory cells and the 2n-1st column of flash memory cells share a bit line set including a first bit line BLS<n-1>, a middle bit line BLM<n-1>, and a second bit line BLD<n-1>.

In addition, according to an embodiment of the present disclosure, the flash memory array further includes a plurality of word line sets extending along the row direction, and each word line set includes a first control line, a word line and a second control line, in which the first control line is connected to the gate electrode of the first storage transistor of the flash memory cell pair, the word line is connected to the gate electrode of the selection transistor of the flash memory cell pair, and the second control line is connected to the gate electrode of the second storage transistor of the flash memory cell pair.

According to an embodiment of the present disclosure, in the flash memory array, flash memory cells (pair) of the same row share the same word line set, that is, the first control line, the word line, and the second control line.

As shown in FIGS. 3 and 4, taking the flash memory cell pair 200 as an example, the flash memory cell pair 200, that is, the first flash memory cell 210 and the second flash memory cell 220, is located in the Oth row, shares the same word line set, that is, the first control line MS0, the word line WLO and the second control line MD0, with other flash memory cells (pairs) in the Oth row. The first control line MSO is connected to the gate electrodes of the first storage transistors 211 and 221 of the first and second flash memory cells 210 and 220, the word line WLO is connected to the gate electrodes of the selection transistors 212 and 222 of the first and second flash memory cells 210 and 220, and the second control line MD0 is connected to the gate electrodes of the second storage transistors 213 and 223 of the first and second flash memory cells 210 and 220.

Similarly, the gate electrodes of the first storage transistors in the flash memory cells (pairs) of the 1st row are commonly connected to the first control line MS1, the gate electrodes of the selection transistors in the flash memory cells of the 1st row are commonly connected to the word line WL1, and the gate electrodes of the second storage transistors in the flash memory cells of the 1st row are commonly connected to the second control line MD1. Similarly, the gate electrodes of the first storage transistors in the flash memory cells of the m-2th row are commonly connected to a first control line MS<m-2>, the gate electrodes of the selection transistors in the flash memory cells of the m-2th row are commonly connected to a word line WL<m-2>, and the gate electrodes of the second storage transistors in the flash memory cells of the m-2th row are commonly connected to a second control line MD <m-2>. Similarly, the gate electrodes of the first storage transistors in the flash memory cells of the m-1th row are commonly connected to a first control line MS<m-1>, the gate electrodes of the selection transistors in the flash memory cells of the m-1th row are commonly connected to a word line WL<m-1>, and the gate electrodes of the second storage transistors in the flash memory cells of the m-1th row are commonly connected to a second control line MD <m-1 >.

Those skilled in the art should appreciate that, the flash memory cells according to an embodiment of the present disclosure has a symmetrical structure, and therefore, based on the connection relationship of the first control line, the word line, the second control line, the first bit line, the middle bit line and the second bit line as described above, the flash memory cells adjacent in the column direction are oppositely disposed, that is, the first storage transistor of the flash memory cell of the current row is adjacent to the first storage transistor of the flash memory cell of the previous row in the column direction, and the second storage transistor of the flash memory cell of the current row is adjacent to the second storage transistor of the flash memory cell of the next row in the column direction; alternatively, the second storage transistor of the flash memory cell of the current row is adjacent to the second storage transistor of the flash memory cell of the previous row in the column direction, and the first storage transistor of the flash memory cell of the current row is adjacent to the first storage transistor of the flash memory cell of the next row in the column direction.

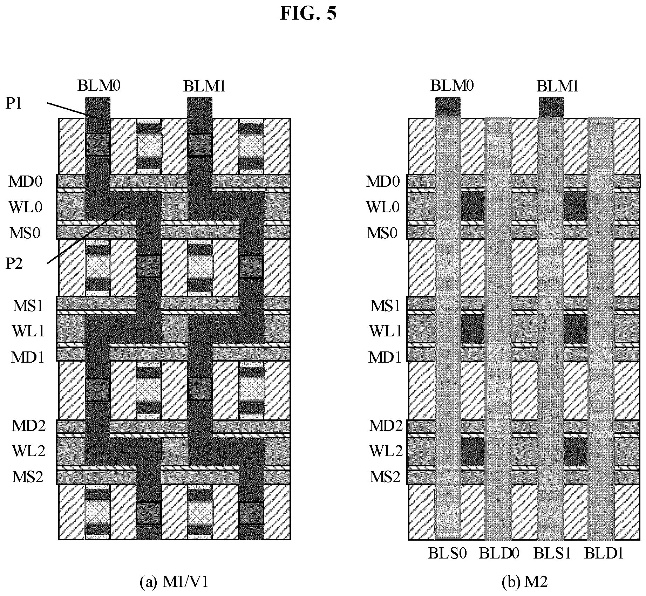

FIG. 5 illustrates a schematic diagram of a layout example of the bit line set according to the first embodiment of the present disclosure.

According to an embodiment of the present disclosure, the first control line, the word line, and the second control line may be formed of at least one of polysilicon, silicide, and a metal gate. According to an embodiment of the present disclosure, the middle bit line may be formed of a first metal layer, and the first bit line and the second bit line may be formed of a second metal layer different from the first metal layer. In other words, the metal layer for forming the middle bit line is different from the metal layer for forming the first bit line and the second bit line. In addition, the first bit line and the second bit line may be formed of the same metal layer.

According to an embodiment of the present disclosure, the first metal layer and the second metal layer may include at least one of the following materials: aluminum, titanium, titanium nitride, copper, tungsten, cobalt, and manganese.

According to an embodiment of the present disclosure, the middle bit line may include a first portion extending in the column direction and a second portion extending in the row direction, and the first bit line and the second bit line extend in the column direction.

As shown in (a) in FIG. 5, taking the flash memory cell pair 200 as an example, the first electrodes S 1 and S2 and the second electrodes D1 and D2 of the first and second flash memory cells 210 and 220 may be formed by a first metal layer M1 disposed above the first control line MS0, the word line WL0, and the second control line MD0 of, for example, polysilicon. As shown in FIG. 5, the first control line MS0, the word line WL0, and the second control line MD0 extend parallel to each other in the row direction.

In addition, as shown in (a) in FIG. 5, the middle bit line BLM0 is formed by the first metal layer M1 in a continuous zigzag manner in the column direction, which includes a first portion P1 extending in the column direction and a second portion P2 extending in the row direction. According to an embodiment of the present disclosure, the second portion P2 of the middle bit line BLM0 may overlap the word line WLO therebelow.

In addition, as shown in (b) in FIG. 5, the first bit line BLS0 and the second bit line BLD0 may be formed by a second metal layer M2 in the column direction and overlap the first portion P1 of the middle bit line BLM0.

According to an embodiment of the present disclosure, the electrical connection between the first bit line BLS0 and the first electrode S 1 of the first flash memory cell 210 may be implemented by a via V1 between the first metal layer M1 and the second metal layer M2, and the electrical connection between the second bit line BLD0 and the second electrode D2 of the second flash memory cell 220 may be implemented by a via V1 between the first metal layer M1 and the second metal layer M2.

According to an embodiment of the present disclosure, since the first portion P1 of the middle bit line may overlap the first bit line and the second bit line, and the second portion P2 of the middle bit line may overlap the word line of polysilicon in the row direction, an additional area for disposing the middle bit line may be eliminated, thereby obtaining a more compact flash memory array. In addition, since the first bit line and the second bit line are both formed of metal, the need for providing a common source line in the prior art is eliminated, thereby further reducing the area of the flash memory array.

The embodiment shown in FIG. 5 uses two metal layers to achieve the arrangement of the first bit line, the middle bit line and the second bit line. However, the present disclosure is not limited thereto. According to an embodiment of the present disclosure, more metal layers may be used to achieve the arrangement of the first bit line, the middle bit line and the second bit line according to the application scenario of the flash memory array.

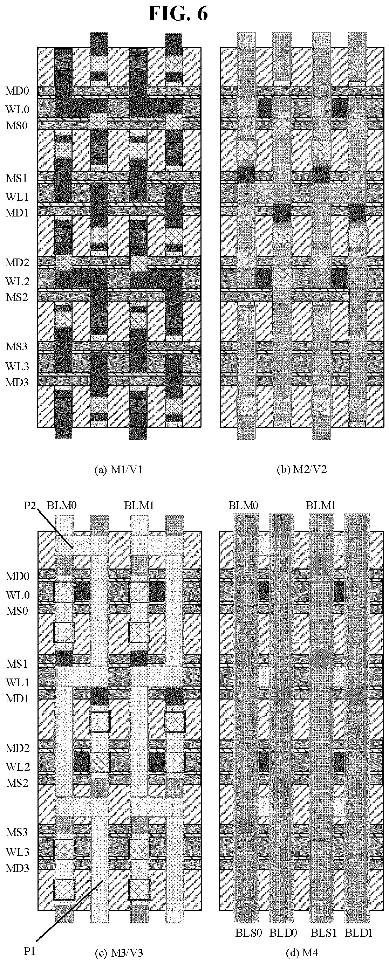

FIG. 6 illustrates a schematic diagram of another layout example of a bit line set according to the first embodiment of the present disclosure.

Specifically, as shown in (a) in FIG. 6, the first electrode and the second electrode of the flash memory cell may be formed by a first metal layer M1 disposed above the first control line, the word line, and the second control line of, for example, polysilicon. Different from FIG. 5, as shown in FIG. 6 (c), the middle bit line may be formed by a third metal layer M3 in a continuous zigzag manner in the column direction. That is, the middle bit line includes a first portion P1 extending in the column direction and a second portion P2 extending in the row direction.

In addition, as shown in (d) in FIG. 6, the first bit line and the second bit line are formed by a fourth metal layer M4 in the column direction, and overlap the first portion P1 of the middle bit line in the column direction. As shown in (b) in FIG. 6, the electrical connections of the middle bit line to the first electrode and the second electrode may be implemented by a second metal layer M2 between the first metal layer M1 and the third metal layer M3 and vias V1 and V2 between the respective metal layers M1 to M3. In addition, as shown in (b) and (c) in FIG. 6, the electrical connection between the first bit line and the first electrode may be implemented by the second metal layer M2 and the third metal layer M3 between the first metal layer M1 and the fourth metal layer M4 and vias V1 to V3 between the respective metal layers M1 to M4. In addition, as shown in (b) and (c) in FIG. 6, the electrical connection between the second bit line and the second electrode may also be implemented by the second metal layer M2 and the third metal layer M3 between the first metal layer M1 and the fourth metal layer M4 and vias V1 to V3 between the respective metal layers M1 to M4.

The bit line layout of four metal layers shown in FIG. 6 allows greater flexibility in the layout of the first bit line, the middle bit line and the second bit line than the bit line layout of two metal layers shown in FIG. 5.

In addition, those skilled in the art should appreciate that the bit line arrangement of the flash memory array according to the present disclosure requires at least two metal layers, and therefore, although FIG. 6 illustrates an embodiment in which four metal layers are used to implement the bit line arrangement of the flash memory array according to the present disclosure, the present disclosure is not limited thereto. According to the teaching of the present disclosure, those skilled in the art may use three metal layers or five or more metal layers to implement the bit line arrangement of the flash memory array according to the present disclosure.

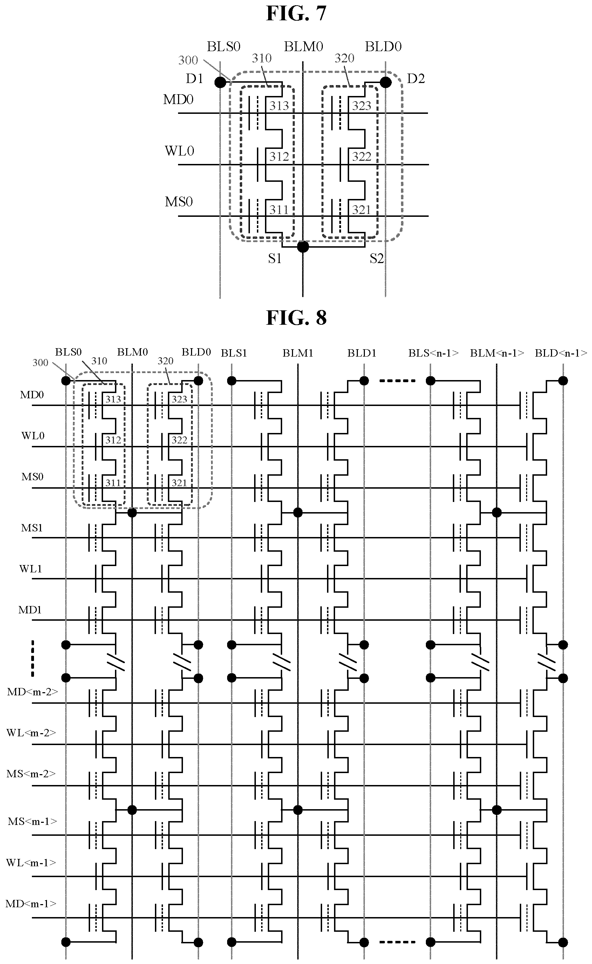

FIG. 7 illustrates a circuit schematic diagram of a flash memory cell pair 300 according to a second embodiment of the present disclosure. FIG. 8 illustrates a circuit schematic diagram of a flash memory array according to the second embodiment of the present disclosure.

As shown in FIG. 7, according to an embodiment of the present disclosure, two flash memory cells adjacent in the row direction may constitute one flash memory cell pair 300, which includes a first flash memory cell 310 and a second flash memory cell 320. For example, the first flash memory cell 310 may be the flash memory cell located in the Oth row and the Oth column in the flash memory array, while the second flash memory cell 320 may be the flash memory cell located in the Oth row and the 1st column in the flash memory array. Therefore, according to an embodiment of the present disclosure, the flash memory array may include flash memory cell pairs arranged in m rows by n columns.

The first flash memory cell 310 includes a first storage transistor 311, a selection transistor 312, and a second storage transistor 313 sequentially connected in series in the column direction. The second flash memory cell 320 includes a first storage transistor 321, a selection transistor 322, and a second storage transistor 323 sequentially connected in series in the column direction.

According to an embodiment of the present disclosure, in the first flash memory cell 310, the source region of the first storage transistor 311 is connected to the first electrode S1 of the first flash memory cell 310, and the drain region of the second storage transistor 313 is connected to the second electrode D1 of the first flash memory cell 310.

In addition, according to an embodiment of the present disclosure, in the second flash memory cell 320, the source region of the first storage transistor 321 is connected to the first electrode S2 of the second flash memory cell 320, and the drain region of the second storage transistor 323 is connected to the second electrode D2 of the second flash memory cell 320.

The flash memory cell pair and the flash memory array of the second embodiment of the present disclosure shown in FIGS. 7 and 8 are substantially the same as the flash memory cell pair and the flash memory array of the first embodiment of the present disclosure shown in FIGS. 3 and 4, except the connection manner of the bit line set of the flash memory cell pair.

Specifically, as shown in FIGS. 7 and 8, according to the second embodiment of the present disclosure, a first bit line BSL0 may be connected to the second electrode D1 of the first flash memory cell 310, a second bit line BLD0 may be connected to the second electrode D2 of the second flash memory cell 320, and a middle bit line BLM0 may be connected to the first electrode S1 of the first flash memory cell 310 and the first electrode S2 of the second flash memory cell 320.

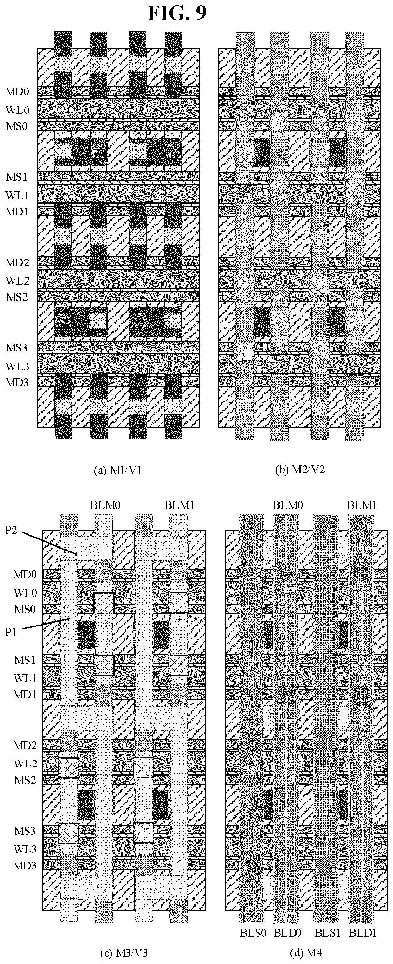

FIG. 9 illustrates a schematic diagram of a layout example of a bit line set according to the second embodiment of the present disclosure.

Specifically, as shown in (a) in FIG. 9, the first electrode and the second electrode of the flash memory cell may be formed by a first metal layer M1 disposed above the first control line, the word line, and the second control line of, such as polysilicon. As shown in (c) in FIG. 9, the middle bit line may be formed by a third metal layer M3 in a continuous zigzag manner in the column direction. That is, the middle bit line includes a first portion P1 extending in the column direction and a second portion P2 extending in the row direction.

In addition, as shown in (d) in FIG. 9, the first bit line and the second bit line are formed by a fourth metal layer M4 in the column direction, and overlap the first portion P1 of the middle bit line in the column direction. As shown in (b) in FIG. 9, the electrical connection of the middle bit line to the first electrode may be implemented by a second metal layer M2 between the first metal layer M1 and the third metal layer M3 and vias V1 and V2 between the respective metal layers M1 to M3. In addition, as shown in (b) and (c) in FIG. 9, the electrical connection between the first bit line and the second electrode may be implemented by the second metal layer M2 and the third metal layer M3 between the first metal layer M1 and the fourth metal layer M4 and vias V1 to V3 between the respective metal layers M1 to M4. In addition, as shown in (b) and (c) in FIG. 9, the electrical connection between the second bit line and the second electrode may also be implemented by the second metal layer M2 and the third metal layer M3 between the first metal layer M1 and the fourth metal layer M4 and vias V1 to V3 between the respective metal layers M1 to M4.

The flash memory array according to the above embodiments of the present disclosure may improve the arrangement density of the bit lines and reduce the parasitic resistance of the bit lines without increasing the size of the array. In addition, compared with the flash memory array of the prior art, the flash memory array according to the present disclosure also has better process compatibility and scaling down characteristics.

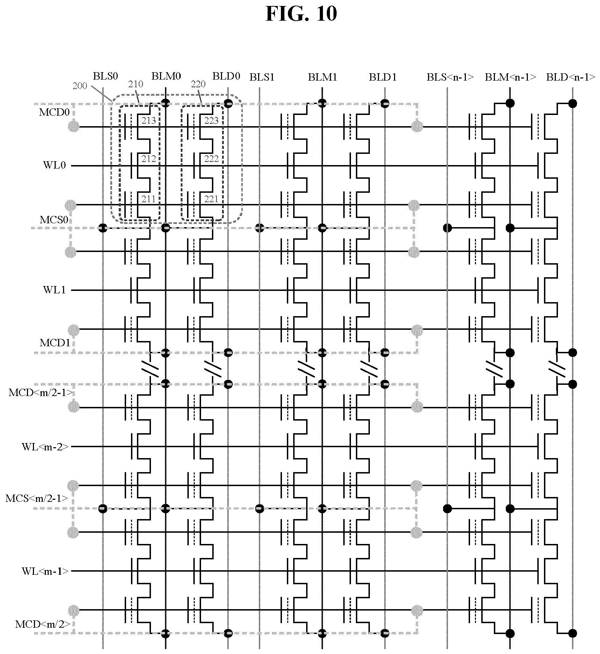

In addition, according to an embodiment of the present disclosure, the first control lines or the second control lines adjacent in the column direction may be connected together by a metal layer. FIG. 10 illustrates a schematic diagram of a layout of control lines of a flash memory array according to an embodiment of the present disclosure.

As shown in FIG. 10, for example, on the basis of the flash memory array shown in FIG. 4, first metal control lines MCS<O:m/2-1> formed of a metal layer may be used to connect first control lines adjacent in the column direction together, and second metal control lines MCD<1:m/2 > formed of the metal layer may also be used to connect the second control lines adjacent in the column direction together.

According to an embodiment of the present disclosure, the metal layer for forming the first metal control lines MCS<O:m/2-1> and the second metal control lines MCD<1:m/2> may be different from the metal layers for forming the bit lines (including the first bit line, the middle bit line and the second bit line). According to an embodiment of the present disclosure, the metal layer for forming the first metal control lines MCS<O:m/2-1> and the second metal control lines MCD<1:m/2> may be disposed above the metal layers for forming the bit lines (including the first bit line, the middle bit line and the second bit line).

According to an embodiment of the present disclosure, two flash memory cells adjacent in the column direction may share a control line (a first control line or a second control line) through a metal control line (a first metal control line or a second metal control line). By connecting the first control line and the second control line together by using the first metal control line and the second metal control line, the parasitic resistance of the first control line and the second control line of, for example, polysilicon may be effectively reduced, so as to effectively increase the operation speed of the flash memory array. In addition, by connecting the first control line and the second control line together using the first metal control line and the second metal control line, the wiring density and the process complexity of the metal control lines may be decreased. In addition, the flash memory array sharing the control lines may also reduce the number of the peripheral circuits of the flash memory array for driving the control lines, thereby reducing the area overhead of the peripheral circuits and the manufacturing cost of the memory chip.

Those skilled in the art should appreciate that, although the flash memory array of the present disclosure is described above in connection with the flash memory cell MC 100 shown in FIG. 1, the flash memory array of the present disclosure is not limited to the flash memory cells MC100 shown in FIG. 1. Those skilled in the art may envisage, according to the teaching of the present disclosure, that the flash memory cell of the present disclosure is applied to other types of flash memory cell, such as a flash memory cell including only one storage transistor or a flash memory cell using one storage transistor to store 2-bit data, all of which should fall within the scope of the present disclosure.

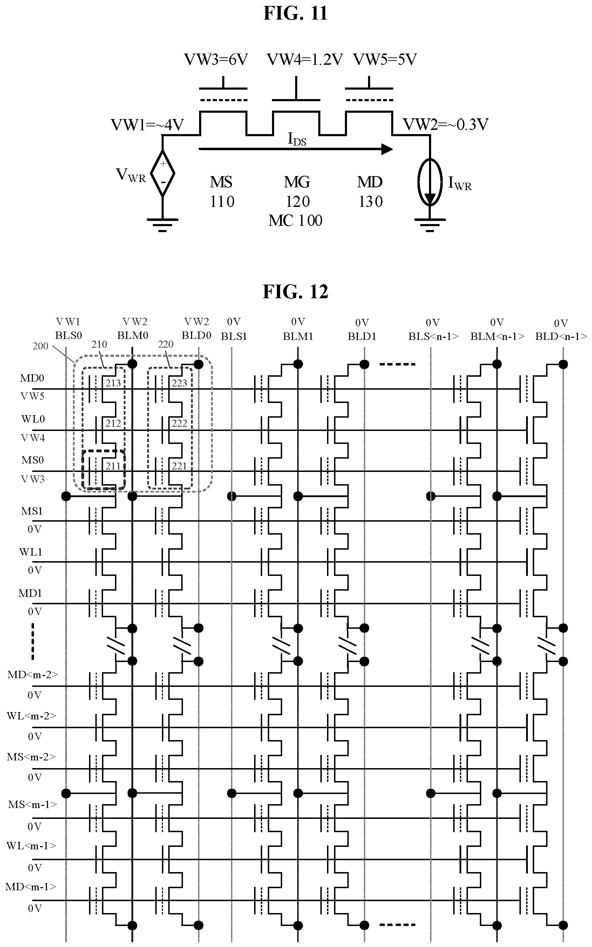

FIG. 11 illustrates an equivalent circuit diagram for performing a write operation on the first storage transistor in the flash memory cell according to an embodiment of the present disclosure.

As shown in FIG. 11, by controlling voltages applied to the source region (that is, the first electrode S) of the first storage transistor MS 110, the gate electrode 116 of the first storage transistor MS 110, the gate electrode 123 of the selection transistor MG 120, the gate electrode 136 of the second storage transistor MD 130, and the drain region (that is, the second electrode D) of the second storage transistor MD 130, a writing operation on the first storage transistor MS 110 may be implemented.

According to an embodiment of the present disclosure, when a writing operation is performed on the flash memory cell MC 100, the well region PW 102 of the flash memory cell MC 100 may be connected to the ground.

Specifically, according to an embodiment of the present disclosure, as shown in FIG. 11, when performing the writing operation on the first storage transistor MS 110 of the flash memory cell MC 100, a first writing voltage VW1 is applied to the first electrode S, a second writing voltage VW2 is applied to the second electrode D, a third writing voltage VW3 is applied to the gate electrode 116 of the first storage transistor MS 110, a fourth writing voltage VW4 is applied to the gate electrode 123 of the selection transistor MG 120, and a fifth writing voltage VW5 is applied to the gate electrode 136 of the second storage transistor MD 130.

According to an embodiment of the present disclosure, the first writing voltage VW1 is higher than a preset voltage, which is predetermined based on the carrier barrier height at the interface between the substrate and the gate dielectric stack 112 of the first storage transistor MS 100. For example, in the flash memory cell MC 100 shown in FIG. 11, the preset voltage may enable electrons to cross the electron barrier at the interface between the P-type channel region 111 and the lower first oxide layer (tunneling oxide) 113 in the gate dielectric stack 112. For example, in the case where the P-type channel region 111 includes silicon and the first oxide layer 113 includes silicon dioxide, the barrier height is 3.2 electron volts (eV). In this case, the first writing voltage VW1 is typically higher than 3 volts (V). For example, the first writing voltage VW1 may be in a range of 3 V to 6 V. According to an embodiment of the present disclosure, the first writing voltage VW1 may be provided by an external constant voltage source.

According to an embodiment of the present disclosure, the second writing voltage VW2 is equal to or higher than a second power voltage VSS, which may be a ground voltage GND. Further, according to an embodiment of the present disclosure, the second writing voltage VW2 is connected to the second power voltage VSS through a constant current load. According to an embodiment of the present disclosure, the second power voltage VSS may be the ground voltage.

According to an embodiment of the present disclosure, the third writing voltage VW3 is higher than the first writing voltage VW1. For example, the third writing voltage VW3 may be in a range of 4V to 12V.

According to an embodiment of the present disclosure, the fourth writing voltage VW4 is equal to or lower than a first power voltage VDD, which is higher than the second power voltage VSS and may be in a range of 0.8 V to 5 V

According to an embodiment of the present disclosure, the first writing voltage VW1, the fourth writing voltage VW4, and the fifth writing voltage VW5 are higher than the second writing voltage VW2. For example, the fifth writing voltage VW5 may be in a range of 3 V to 8 V

Also, according to an embodiment of the present disclosure, during the writing operation of the flash memory cell MC 100, the first to fifth writing voltages VW1 to VW5 turn on all the first storage transistor MS 110, the second storage transistor MD 130, and the selection transistor MG 120.

Because of the symmetrical structure of the flash memory cell MC 100, there is also a symmetrical relationship between the respective writing voltages VW1 to VW5 applied during the writing operation of the first storage transistor MS 110 and the second storage transistor MD 130. Therefore, repetitive description of the writing voltages applied during the writing operation of the second storage transistor MD 130 is not made here for brevity.

As shown in FIG. 11, an on-current I_{DS} (that is, the current flowing between the first electrode S and the second electrode D of the flash memory cell MC 100) of the flash memory cell during writing may be accurately controlled by adjusting a constant current I_{WR} of the externally connected constant current load, so as to achieve the purpose of adjusting the programming threshold voltage, thereby improving the writing (programming) threshold voltage distribution accuracy of the flash memory cell array.

According to an embodiment of the present disclosure, the writing operation on the first storage transistor MS 110 and the second storage transistor MD 130 described above employs a channel hot electron injection mechanism of a low gate voltage.

According to an embodiment of the present disclosure, the constant current load may be implemented by a current mirror circuit.

Specifically, as shown in FIG. 11, a constant voltage V_{WR} (that is, the first writing voltage VW1) of, for example, about 4 V is applied to the first electrode S, and the constant current load having a pull-down function (having the constant current I_{WR} ) is connected to the second electrode D to pull the voltage at the second electrode D (that is, the second writing voltage VW2) down to between 0 V to 1 V, for example, about 0.3 V In addition, the third writing voltage VW3 of, for example, 6 V is applied to the gate electrode 116 of the first storage transistor MS 110, a fourth writing voltage VW4 of, for example, 1.2 V is applied to the gate electrode 123 of the selection transistor MG 120, and a fifth writing voltage VW5 of, for example, 5 V is applied to the gate electrode 136 of the second storage transistor MD 130, so that the first storage transistor MS 110, the second storage transistor MD 130, and the selection transistor MG 120 of the flash memory cell MC 100 are all turned on.

In addition, since the gate voltage VW4 of the selection transistor MG 120 is a low voltage, so that the selection transistor MG 120 is in a low gate voltage saturated on-state, and therefore, the on-current I_{DS} of the entire flash memory cell MC 100 is determined by the on-current of the selection transistor MG 120. When the on-current I_{DS} of the flash memory cell MC 100 is greater than the constant current I_{WR} of the constant current load, the second electrode D of the flash memory cell MC 100 may be charged to increase its voltage VW2, thereby the gate on-voltage (V_{GS} = VW4 - VW2) of the selection transistor MG 120 decreases, so that the on-current I_{DS} decreases and adaptively becomes the constant current I_{WR} of the constant current load. In contrast, when the on-current I_{DS} of the flash memory cell MC 100 is less than the constant current I_{WR} of the constant current load, the second electrode D of the flash memory cell MC 100 is discharged to decrease its voltage VW2, thereby the gate on-voltage (V_{GS} = VW4 - VW2) of the selection transistor MG 120 increases, so that the on-current I_{DS} increases and adaptively becomes the constant current I_{WR} of the constant current load.

Through this adaptive effect, during programming of the flash memory cell MC 100, the on-current I_{DS} is constantly equal to the constant current I_{WR} of the constant current load without being affected by factors such as the threshold voltage of the flash memory cell MC 100, process deviation, etc. Further, according to the lucky electron model of the channel hot electron injection mechanism, since the on-current I_{DS} during the writing operation of the flash memory cell MC 100 according to the present disclosure is constant and precisely controllable, the gate program (write) current is the on-current I_{DS} (constantly equal to constant current I_{WR} ) multiplied by the injection probability coefficient P_{INJ}, which may be regarded as a constant, so that the accuracy of programming threshold voltage may be substantially improved.

FIG. 12 illustrates a schematic diagram of performing a write operation on the first storage transistor 211 of the first flash memory cell 210 according to an embodiment of the present disclosure.

According to an embodiment of the present disclosure, as shown in FIG. 12, when performing the write operation on the first storage transistor 211 of the first flash memory cell 210, the first writing voltage VW1 of, for example, 4 V is applied to the first bit line BLSO, the second writing voltage VW2 of, for example, 0.2 V is applied to the middle bit line BLM0 and the second bit line BLDO, the third writing voltage VW3 of, for example, 6 V is applied to the first control line MSO connected to the gate electrode of the first storage transistor 211, the fourth writing voltage VW4 of, for example, 1.2 V is applied to the word line WLO connected to the gate electrode of the selection transistor 212, and the fifth writing voltage VW5 of, for example, 5 V is applied to the second control line MD0 connected to the gate electrode of the second storage transistor 213.

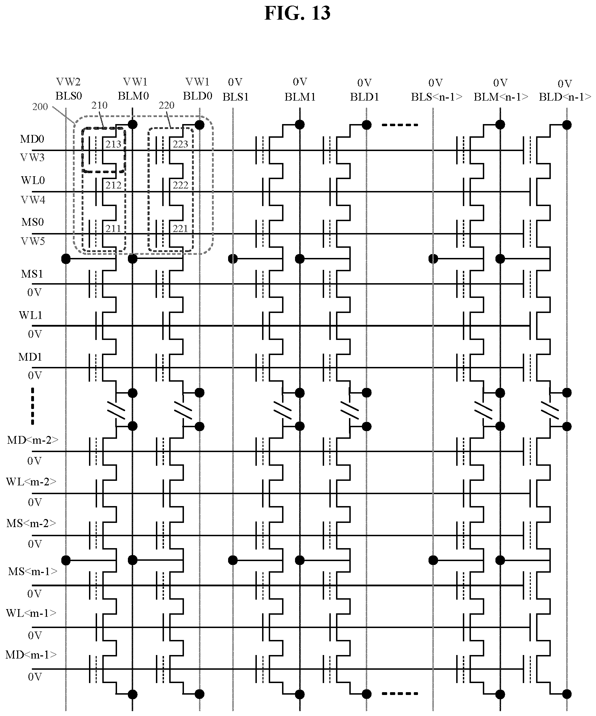

FIG. 13 illustrates a schematic diagram of performing a write operation on the second storage transistor 213 of the first flash memory cell 210 according to an embodiment of the present disclosure.

According to an embodiment of the present disclosure, as shown in FIG. 13, when performing the write operation on the second storage transistor 213 of the first flash memory cell 210, the second writing voltage VW2 of, for example, 0.2 V is applied to the first bit line BLSO, the first writing voltage VW1 of, for example, 4 V is applied to the middle bit line BLM0 and the second bit line BLDO, the fifth writing voltage VW5 of, for example, 5 V is applied to the first control line MSO connected to the gate electrode of the first storage transistor 211, the fourth writing voltage VW4 of, for example, 1.2 V is applied to the word line WLO connected to the gate electrode of the selection transistor 212, and the third writing voltage VW3 of, for example, 6 V is applied to the second control line MD0 connected to the gate electrode of the second storage transistor 213.

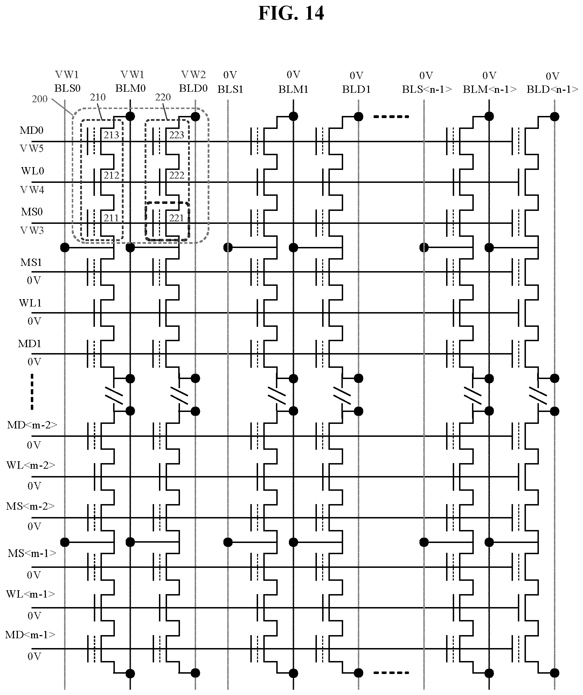

FIG. 14 illustrates a schematic diagram of performing a write operation on the first storage transistor 221 of the second flash memory cell 220 according to an embodiment of the present disclosure.

According to an embodiment of the present disclosure, as shown in FIG. 14, when performing the write operation on the first storage transistor 221 of the second flash memory cell 220, the first writing voltage VW1 of, for example, 4 V is applied to the first bit line BLS0 and the middle bit line BLMO, the second writing voltage VW2 of, for example, 0.2 V is applied to the second bit line BLDO, the third writing voltage VW3 of, for example, 6 V is applied to the first control line MSO connected to the gate electrode of the first storage transistor 221, the fourth writing voltage VW4 of, for example, 1.2 V is applied to the word line WLO connected to the gate electrode of the selection transistor 222, and the fifth writing voltage VW5 of, for example, 5 V is applied to the second control line MD0 connected to the gate electrode of the second storage transistor 223.

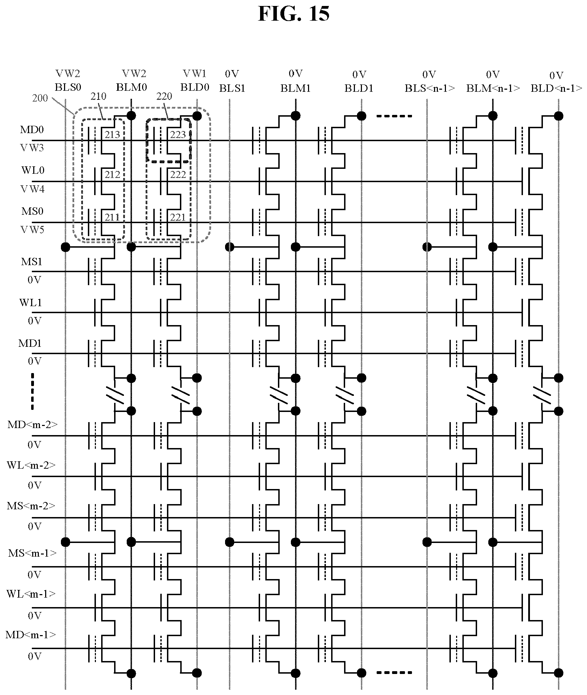

FIG. 15 illustrates a schematic diagram of performing a write operation on the second storage transistor 223 of the second flash memory cell 220 according to an embodiment of the present disclosure.

According to an embodiment of the present disclosure, as shown in FIG. 15, when performing the write operation on the second storage transistor 223 of the second flash memory cell 210, the second writing voltage VW2 of, for example, 0.2 V is applied to the first bit line BLS0 and the middle bit line BLMO, the first writing voltage VW1 of, for example, 4 V is applied to the second bit line BLDO, the fifth writing voltage VW5 of, for example, 5 V is applied to the first control line MSO connected to the gate electrode of the first storage transistor 221, the fourth writing voltage VW4 of, for example, 1.2 V is applied to the word line WLO connected to the gate electrode of the selection transistor 222, and the third writing voltage VW3 of, for example, 6 V is applied to the second control line MD0 connected to the gate electrode of the second storage transistor 223.

According to an embodiment of the present disclosure, as shown in FIGS. 12 to 15, in the write method of the flash memory array according to the present disclosure, when performing the write operation on the flash memory cell pair 200, except the bit line set BLSO, BLMO, and BLD0 and the word line set MS0, WL0, and MD0 connected to the flash memory cell pair 200, other word line sets and bit line sets may all be connected to the ground voltage, for example, 0 V

As can be seen, in the writing method of the flash memory array according to the present disclosure, in the bit line set connected to a flash memory cell pair in a selected column, only at most two bit lines need to be charged to a high writing voltage, so that the power consumption caused by charging the parasitic capacitance of the bit line may be greatly reduced, and therefore, compared with the existing writing method of the flash memory array, the writing method of the flash memory array according to the present disclosure has the advantage of low power consumption. In addition, the advantage of low power consumption of the writing method of the flash memory array of the present disclosure is beneficial to increasing the number of the flash memory cells written in parallel, thereby increasing the data write-throughput of the flash memory array and overcoming the defect of slow data writing of the existing NOR type flash memory.

Those skilled in the art should appreciate that although the writing method of the flash memory array of the present disclosure is described above in connection with the flash memory cell MC 100 shown in FIG. 1, the writing method of the flash memory array of the present disclosure is not limited to the flash memory cell MC 100 shown in FIG. 1. Those skilled in the art may envisage, according to the teaching of the present disclosure, that the writing method of the flash memory array of the present disclosure is applied to other types of flash memory cell, such as a flash memory cell including only one storage transistor or a flash memory cell using one storage transistor to store 2-bit data, all of which should fall within the scope of the present disclosure.

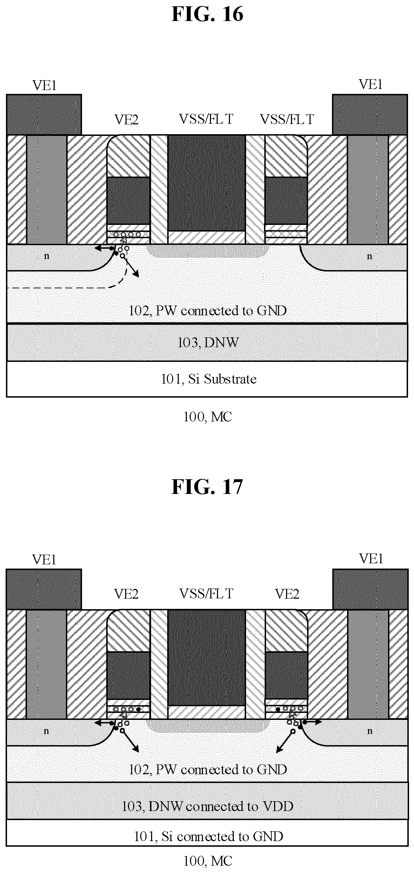

FIG. 16 illustrates a conceptual schematic diagram of performing an erasing operation on the first storage transistor by a first erasing step according to an embodiment of the present disclosure.

According to an embodiment of the present disclosure, when performing the erasing operation on the flash memory cell MC 100, the well region PW 102 of the flash memory cell MC 100 may be connected to the ground.

Specifically, according to an embodiment of the present disclosure, as shown in FIG. 16, when performing the erasing operation on the first storage transistors MS 110 of the flash memory cells MC 100 by the first erasing step, the second power voltage VSS is applied to the well region PW 102, a first erasing voltage VE1 is applied to the first electrodes S and the second electrodes D, the second power voltage VSS is applied to the gate electrode 123 of the selection transistor MG 120 and the gate electrode 136 of the second storage transistor MD 130 or the gate electrode 123 of the selection transistor MG 120 and the gate electrode 136 of the second storage transistor MD 130 are floated (floating is denoted by FLT in the drawings), and a second erasing voltage VE2 is applied to the gate electrode 116 of the first storage transistor MS110. For example, the second power voltage VSS may be the ground voltage, for example, 0 V

According to an embodiment of the present disclosure, the first erasing voltage VE1 is higher than a preset voltage VP, which is predetermined according to the carrier barrier height at the interface between the substrate and the gate dielectric stack 112 of the first storage transistor MS 100. For example, in the flash memory cell MC 100 shown in FIG. 1, the preset voltage VP may enable holes to cross the hole barrier at the interface between the P-type channel region 111 and the lower first oxide layer (tunneling oxide) 113 in the gate dielectric stack 112. For example, in the case where the P-type channel region 111 includes silicon and the first oxide layer 113 includes silicon dioxide, the barrier height is 4.8 electron volts (eV). In this case, the first erasing voltage VE1 is typically higher than 4 volts (V). For example, the first erasing voltage VE1 may be in a range of 3 V to 6 V For example, the first erasing voltage VE1 may be 4 V.

According to an embodiment of the present disclosure, the second erasing voltage VE2 is equal to or lower than the second power voltage VSS, which may be the ground voltage GND. Further, according to an embodiment of the present disclosure, the second erasing voltage VE2 may be in a range of -8 V to 0 V For example, the second erasing voltage VE2 may be -6 V

Similarly, according to an embodiment of the present disclosure, when performing the erasing operation on the second storage transistors MD 130 of the flash memory cells MC 100 by the first erasing step, the first erasing voltage VE1 is applied to the first electrode S and the second electrode D, the second power voltage VSS is applied to the gate electrode 123 of the selection transistor MG 120 and the gate electrode 116 of the first storage transistor MS1 10 or the gate electrode 123 of the selection transistor MG 120 and the gate electrode 116 of the first storage transistor MS110 are floated, and the second erasing voltage VE2 is applied to the gate electrode 116 of the second storage transistor MD 130.

As can be seen, because of the symmetrical structure of the flash memory cell MC 100, there is also a symmetrical relationship between the respective erasing voltages VE1 and VE2 applied during erasing of the first storage transistor MS 110 and the second storage transistor MD 130 using the first erasing step. Therefore, repetitive description of the erasing voltages applied during the erasing operation of the second storage transistor MD 130 is not made here for brevity.

In addition, according to an embodiment of the present disclosure, the erasing operation may also be simultaneously performed on the first storage transistor MS 110 and the second storage transistor MD 130 of the flash memory cell MC 100 by a second erasing step. FIG. 17 illustrates a conceptual schematic diagram of simultaneously performing an erasing operation on the first storage transistor and the second storage transistor by a second erasing step according to an embodiment of the present disclosure.

According to an embodiment of the present disclosure, as shown in FIG. 17, when simultaneously performing the erasing operation on the first storage transistor MS 110 and the second storage transistor MD 130 by the second erasing step, the first erasing voltage VE1 is applied to the first electrode S and the second electrode D, the second power voltage VSS is applied to the gate electrode 123 of the selection transistor MG 120 or the gate electrode 123 of the selection transistor MG 120 is floated, and the second erasing voltage VE2 is applied to the gate electrode 116 of the first storage transistor MS110 and the gate electrode 136 of the second storage transistor MD 130.

According to an embodiment of the present disclosure, the erasing operations performed on the first storage transistor MS 110 and the second storage transistor MD 130 by the first erasing step and the second erasing step described above adopt a band-to-band tunneling hot carrier injection mechanism. Taking the erasing operation on the first storage transistor MS 110 as an example, the junction at the first electrode S of the flash memory cell MC 100 is in a high voltage reverse bias state, and therefore, under the action of the second erasing voltage VE2 (a negative gate voltage) applied to the gate electrode 116, the band-to-band tunneling physical effect occurs in the depletion region of the junction, and the hot holes generated by the band-to-band tunneling are injected into the storage dielectric layer 114 such as silicon nitride. The hot holes may recombine with the electrons stored during the writing (programming) operation of the flash memory cell MC 100, such that the threshold voltage of the first storage transistor MS 110 decreases. In addition, since the flash memory cell MC100 is in an off-state at this time, this erasing operation does not result in an on-current, so that this has the advantage of low power consumption.

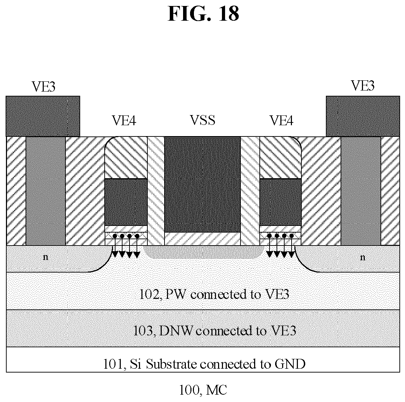

FIG. 18 illustrates a conceptual schematic diagram of performing an erasing operation on the first storage transistor and the second storage transistor by a third erasing step according to an embodiment of the present disclosure.

According to an embodiment of the present disclosure, the erasing operation may also be simultaneously performed on the first storage transistor MS 110 and the second storage transistor MD 130 of the flash memory cell MC 100 by the third erasing step. According to an embodiment of the present disclosure, when performing the erasing operation simultaneously on the first storage transistor MS 110 and the second storage transistor MD 130, a third erasing voltage VE3 is applied to the well region PW 102, the first electrode S, and the second electrode D, the second power voltage VSS is applied to the gate electrode 123 of the selection transistor MG 120, and a fourth erasing voltage VE4 is applied to the gate electrode 116 of the first storage transistor MS110 and the gate electrode 136 of the second storage transistor MD 130.

According to an embodiment of the present disclosure, the third erasing voltage VE3 may be in a range of 0 V to 20 V For example, the third erasing voltage VE3 may be 6 V According to an embodiment of the present disclosure, the fourth erasing voltage VE4 may be in a range of -10 V to 0 V For example, the fourth erasing voltage VE4 may be -6 V

In addition, according to an embodiment of the present disclosure, the third erasing voltage VE3 used in the third erasing step may be the same as or different from the first erasing voltage VE1 used in the first erasing step and the second erasing step described above, and the fourth erasing voltage VE4 used in the third erasing step may be the same as or different from the second erasing voltage VE2 used in the first erasing step and the second erasing step described above.

According to an embodiment of the present disclosure, the erasing operation performed on the first storage transistor MS 110 and the second storage transistor MD 130 by the third erasing step described above adopts an FN (Fowler-Nordheim) tunneling mechanism. Taking the erasing operation on the first storage transistor MS 110 as an example, the third erasing voltage VE3, which is a relatively high voltage, is applied to the first electrode S and the well region PW 102 (substrate) of the flash memory cell MC 100, the fourth erasing voltage VE4, which is a negative voltage or ground voltage, is applied to the gate electrode 116 (controlling gate) of the first storage transistor MS 110, and therefore, under the action of the gate reverse electric field, the written (programmed) electron charges stored in the storage dielectric layer 114 is pulled out from the substrate through the FN tunneling mechanism, such that the threshold voltage of the first storage transistor MS 110 decreases. In addition, since the flash memory cell MC100 is in an off-state at this time and there is no voltage difference between the first electrode S and the second electrode D thereof, this erasing operation does not result in an on-current, so that this erasing method of the flash memory cell according to the present disclosure has an advantage of low power consumption.

It should be explained that the erasing operation of the third erasing step based on the FN tunneling mechanism according to the present disclosure has a lower operation current than the first erasing step and the second erasing step based on the band-to-band tunneling hot hole injection mechanism, and therefore, is suitable for erasing more rows of flash memory cells simultaneously and thus supports the erasing operation of the flash memory array with larger capacity. However, because of the trap trapping effect of written (programmed) electron charges in the storage dielectric layer such as silicon nitride, it is difficult for the trapping electrons to be excited by a longitudinally reverse electric field away from the electron traps and tunneled into the substrate. As such, the erasing operation of the third erasing step based on the FN tunneling mechanism has a higher erasing voltage, a slower operation speed and a smaller erasing window compared with the erasing operations of the first erasing step and the second erasing step based on the band-to-band tunneling hot carrier injection mechanism.

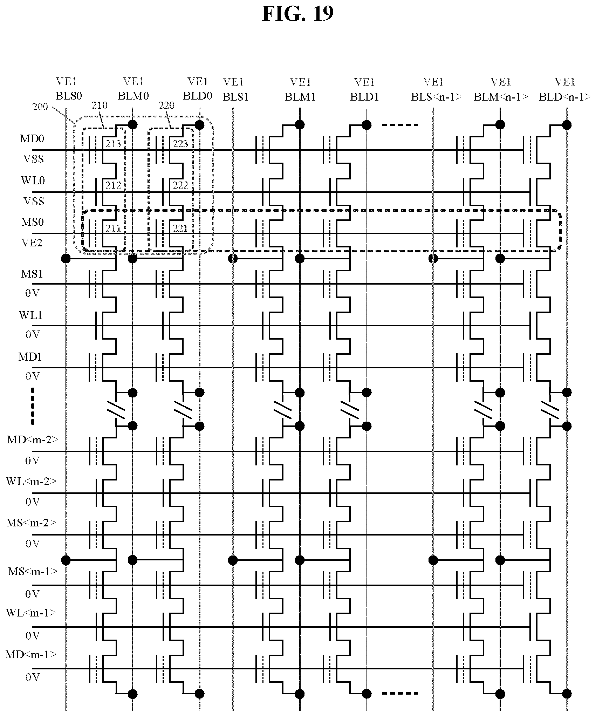

FIG. 19 illustrates a schematic diagram of performing an erasing operation on the first storage transistors 211 and 221 of the first flash memory cell 210 and the second flash memory cell 220 by the first erasing step according to an embodiment of the present disclosure.

According to an embodiment of the present disclosure, as shown in FIG. 19, when performing the erasing operation on the first storage transistors 211 and 221 of the first flash memory cell 210 and the second flash memory cell 220, the first erasing voltage VE1 of, for example, 4 V is applied to the first bit line BLSO, the middle bit line BLMO, and the second bit line BLDO, the second erasing voltage VE2 of, for example, -6 V is applied to the first control line MSO connected to the gate electrodes of the first storage transistors 211 and 221, and the second power voltage VSS is applied to the word line WLO connected to the gate electrodes of the selection transistors 212 and 222 and the second control line MD0 connected to the gate electrodes of the second storage transistors 213 and 223 or the word line WLO and the second control line MD0 are floated.

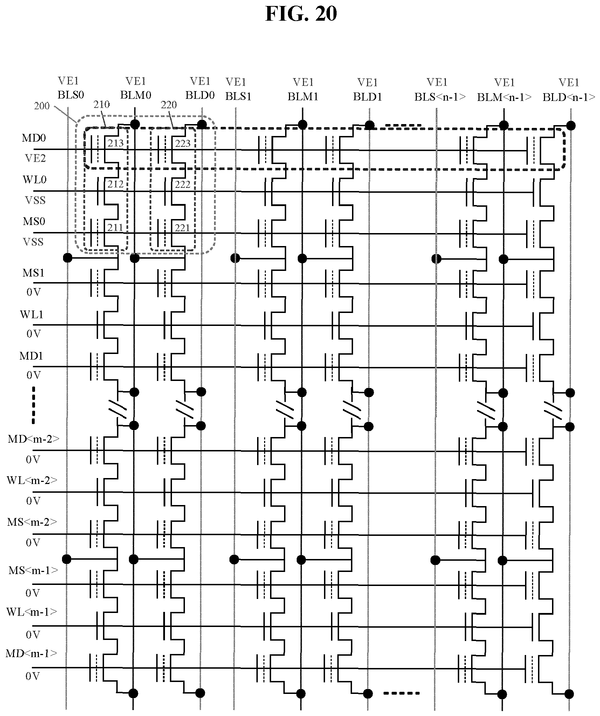

FIG. 20 illustrates a schematic diagram of performing an erasing operation on the second storage transistors 213 and 223 of the first flash memory cell 210 and the second flash memory cell 220 by the first erasing step according to an embodiment of the present disclosure.

According to an embodiment of the present disclosure, as shown in FIG. 20, when performing an erasing operation on the second storage transistors 213 and 223 of the first flash memory cell 210 and the second flash memory cell 220 by the first erasing step, the first erasing voltage VE1 of, for example, 4 V is applied to the first bit line BLSO, the middle bit line BLMO, and the second bit line BLDO, the second erasing voltage VE2 of, for example, -6 V is applied to the second control line MD0 connected to the gate electrodes of the second storage transistors 213 and 223, and the second power voltage VSS is applied to the word line WLO connected to the gate electrodes of the selection transistors 212 and 222 and the first control line MSO connected to the gate electrodes of the first storage transistors 211 and 221 or the word line WLO and the first control line MSO are floated.

According to an embodiment of the present disclosure, as shown in FIGS. 19 and 20, the first storage transistors or the second storage transistors in one or more rows of flash memory cells may be simultaneously erased using the first erasing step. In addition, according to an embodiment of the present disclosure, when performing the erasing operation by the first erasing step, all bit line sets of the flash memory array may be connected to the first erasing voltage VE1. For the rows of flash memory cells on which the erasing operation is not performed, word line sets thereof may be connected to the second power voltage VSS or floated.

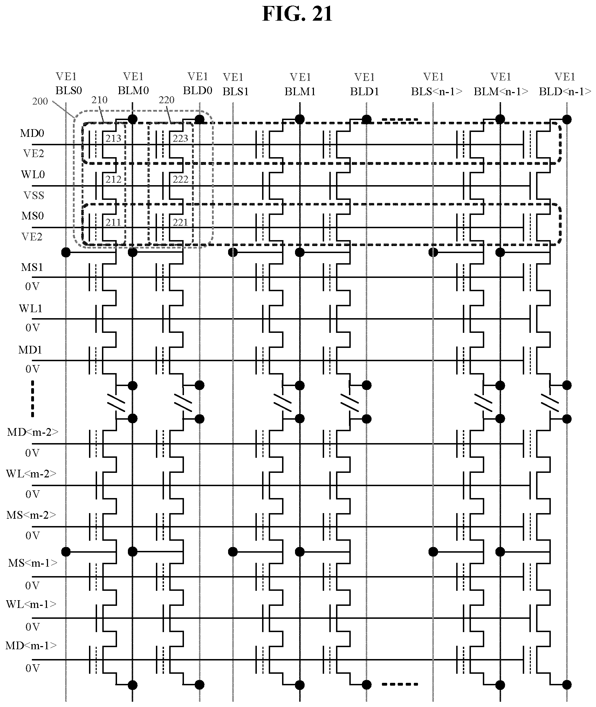

FIG. 21 illustrates a schematic diagram of performing an erasing operation on the first flash memory cell 210 and the second flash memory cell 220 by the second erasing step according to an embodiment of the present disclosure.

According to an embodiment of the present disclosure, as shown in FIG. 21, when simultaneously performing the erasing operation on the first storage transistors 211 and 221 and the second storage transistors 213 and 223 of the first flash memory cell 210 and the second flash memory cell 220 by the second erasing step, the first erasing voltage VE1 of, for example, 4 V is applied to the first bit line BLSO, the middle bit line BLMO, and the second bit line BLDO, the second erasing voltage VE2 of, for example, -6 V is applied to the first control line MSO connected to the gate electrodes of the first storage transistors 211 and 221 and the second control line MD0 connected to the gate electrodes of the second storage transistors 213 and 223, and the second power voltage VSS is applied to the word line WLO connected to the gate electrodes of the selection transistors 212 and 222 or the word line WLO is floated.

According to an embodiment of the present disclosure, as shown in FIG. 21, the first storage transistors and the second storage transistors in one or more rows of flash memory cells may be simultaneously erased using the second erasing step. In addition, according to an embodiment of the present disclosure, all bit line sets of the flash memory array may be connected to the first erasing voltage VE1 when the erasing operation is performed by the second erasing step. For the rows of flash memory cells on which the erasing operation is not performed, the word line sets thereof may be connected to the second power voltage VSS or floated.

According to an embodiment of the present disclosure, as shown in FIGS. 19 to 21, through the first erasing step or the second erasing step, the erasing operation may be simultaneously performed on the selected one or more rows of memory cells or on the first storage transistor or the second storage transistor in the selected row of flash memory cells.

According to an embodiment of the present disclosure, as shown in FIGS. 19 to 21, when performing the erasing operation of the flash memory array by the first erasing step or the second erasing step, the first erasing voltage VE1 is applied to the first bit lines BLS<O:n-1>, the middle bit lines BLM <O:n-1>, and the second bit lines BLD <O:n-1> of the flash memory array.

According to an embodiment of the present disclosure, as shown in FIGS. 19 to 21, for the flash memory cell on which the erasing operation is not performed, the first control line, the word line, and the second control line thereof are applied with the second power voltage VSS or floated.

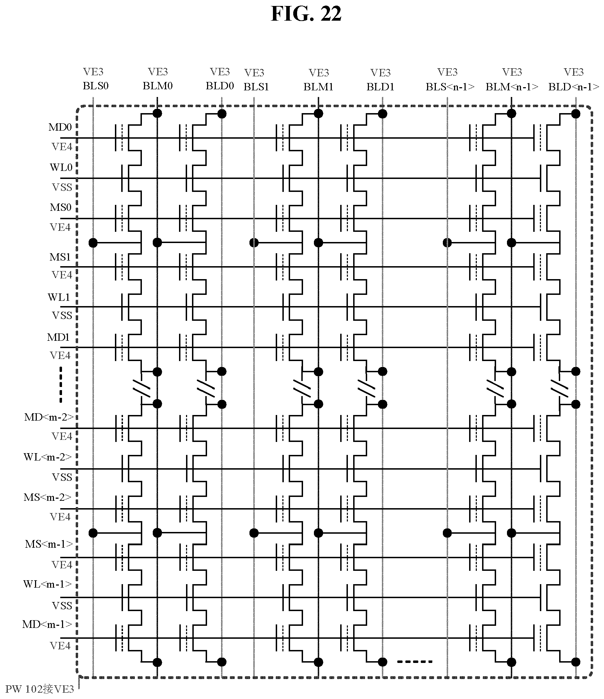

FIG. 22 illustrates a schematic diagram of performing an erasing operation on the first flash memory cell and the second flash memory cell by the third erasing step according to an embodiment of the present disclosure.

According to an embodiment of the present disclosure, as shown in FIG. 22, when simultaneously performing the erasing operation on the first storage transistors 211 and 221 and the second storage transistors 213 and 223 of the first flash memory cell 210 and the second flash memory cell 220 by the third erasing step, the third erasing voltage VE3 of, for example, 6 V is applied to the well region PW102 of the flash memory array, the first bit line BLSO, the middle bit line BLMO, and the second bit line BLDO, the fourth erasing voltage VE4 of, for example, -6 V is applied to the first control line MSO connected to the gate electrodes of the first storage transistors 211 and 221 and the second control line MD0 connected to the gate electrodes of the second storage transistors 213 and 223, and the second power voltage VSS is applied to the word line WLO connected to the gate electrodes of the selection transistors 212 and 222 or the word line WLO is floated.

According to an embodiment of the present disclosure, as shown in FIG. 22, through the third erasing step, the erasing operation may be performed on the entire flash memory array at the same time.

In addition, as described above, according to an embodiment of the present disclosure, the third erasing voltage VE3 used in the third erasing step may be the same as or different from the first erasing voltage VE1 used in the first erasing step and the second erasing step described above, and the fourth erasing voltage VE4 used in the third erasing step may be the same as or different from the second erasing voltage VE2 used in the first erasing step and the second erasing step described above.

According to an embodiment of the present disclosure, as shown in FIG. 22, when performing the erasing operation on the entire flash memory array, the third erasing voltage VE3 is applied to the well region PW 102 of the flash memory array, the first bit lines BLS <0:n-1>, the middle bit lines BLM <O:n-1>, and the second bit lines BLD <O:n-1>, the fourth erasing voltage VE4 is applied to the first control lines MS <O:m-1> and the second control lines MD<0:m-1>, and the second power voltage VSS is applied to the word lines WL <O:m-1> or the word lines WL<0:m-1> are floated.

As described above, compared with the erasing operations by the first erasing step and the second erasing step based on the band-to-band tunneling hot carrier injection mechanism, the erasing operation by the third erasing step based on the FN tunneling mechanism is suitable for simultaneously performing the erasing operation on more rows of and even the entire flash memory array, but has a higher erasing voltage, a slower operation speed, and a smaller erasing window. According to an embodiment of the present disclosure, the first (second) erasing step may be used in combination with the third erasing step to achieve an optimal trade-off of erasing speed and erasing effect. Specifically, firstly the erasing operation may be performed on more rows of or all the flash memory cells using the third erasing step based on the FN tunneling mechanism, such that the characteristic of small operation current of the FN tunneling effect is utilized, and more rows of flash memory cells are selected to perform the erasing operation simultaneously, so as to erase the threshold voltages of the selected flash memory cells to a lower state. Subsequently, the erasing operation may be performed on one row or less rows of flash memory cells using the first erasing step or the second erasing step based on the band-to-band tunneling hot carrier injection mechanism, thereby erasing the selected flash memory cells to a much lower threshold voltage state using recombination of the injected holes.

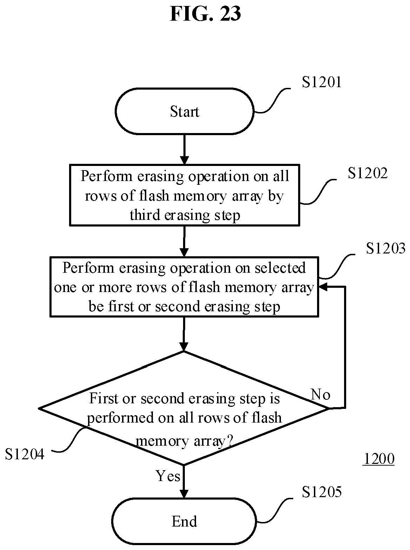

FIG. 23 illustrates a flowchart of an erasing method 1200 of the flash memory array according to an embodiment of the present disclosure.

The erasing method 1200 starts with step S1201. Subsequently, in step S1202, an erasing operation on all rows of the flash memory array is performed by the third erasing step. In step S1203, one or more rows of flash memory cells of the flash memory array are selected, and an erasing operation is performed on the selected rows of flash memory cells by the first erasing step or the second erasing step. In addition, in step S1203, the row addresses of the rows of flash memory cells on which the first erasing step or the second erasing step has been performed may also be stored. Subsequently, in step S1204, it is determined whether the first erasing step or the second erasing step has been performed on all the rows of the flash memory array. If yes, the erasing method 1200 ends at step S1205. Otherwise, the erasing method 1200 returns to step S1203, and according to the previously stored row addresses, the erasing operation is performed on the flash memory cells of the rows on which the first erasing step and the second erasing step are not performed.

By the multi-step combined erasing method according to an embodiment of the present disclosure, the first erasing step and/or the second erasing step can be combined with the third erasing step, to obtain a lower erasing threshold voltage while decreasing the erasing voltage and the erasing time, thereby improving the erasing operation speed and increasing the erasing operation threshold voltage window of the flash memory cell and the reliability of storage.

Those skilled in the art should appreciate that although the erasing method of the flash memory array of the present disclosure is described above in connection with the flash memory cell MC 100 shown in FIG. 1, the erasing method of the flash memory array of the present disclosure is not limited to the flash memory cell MC 100 shown in FIG. 1. Those skilled in the art may envisage, according to the teaching of the present disclosure, that the erasing method of the flash memory array of the present disclosure is applied to other types of flash memory cell, such as a flash memory cell including only one storage transistor or a flash memory cell using one storage transistor to store 2-bit data, all of which should fall within the scope of the present disclosure.

Although the present disclosure has been described with reference to the embodiments thereof, those skilled in the art should appreciate that various modifications and changes may be made to the present disclosure without departing from the spirit and scope of the present disclosure as disclosed in the attached claims.

## Claims

1. A flash memory array comprising:
a plurality of flash memory cells arranged in a row direction and a column direction perpendicular to the row direction;
a plurality of word line sets extending in the row direction; and
a plurality of bit line sets extending in the column direction,
wherein a flash memory cell pair is disposed at an intersection of the word line set and the bit line set, and the flash memory cell pair includes a first flash memory cell and a second flash memory cell adjacent in the row direction and sharing the same bit line set.

2. The flash memory array according to claim 1,
wherein each of the first flash memory cell and the second flash memory cell includes a first storage transistor, a selection transistor, and a second storage transistor sequentially connected in series in the column direction, and
wherein, in each of the first flash memory cell and the second flash memory cell, a source region of the first storage transistor is connected to a first electrode of the flash memory cell, and a drain region of the second storage transistor is connected to a second electrode of the flash memory cell.

3. The flash memory array according to claim 2,
wherein each bit line set includes a first bit line, a middle bit line, and a second bit line, the first bit line is connected to the first electrode of the first flash memory cell of the flash memory cell pair, the second bit line is connected to the second electrode of the second flash memory cell of the flash memory cell pair, and the middle bit line is connected to the second electrode of the first flash memory cell and the first electrode of the second flash memory cell.

4. The flash memory array according to claim 2,
wherein each bit line set includes a first bit line, a middle bit line, and a second bit line, the first bit line is connected to the second electrode of the first flash memory cell of the flash memory cell pair, the second bit line is connected to the second electrode of the second flash memory cell of the flash memory cell pair, and the middle bit line is connected to the first electrode of the first flash memory cell and the first electrode of the second flash memory cell.

5. The flash memory array according to claim 3 or 4,
wherein each word line set includes a first control line, a word line and a second control line extending along the row direction, the first control line is connected to a gate electrode of the first storage transistor, the word line is connected to a gate electrode of the selection transistor, and the second control line is connected to a gate electrode of the second storage transistor.

6. The flash memory array according to claim 5, wherein
two first control lines adjacent in the column direction are connected together by a first common control line, and
two second control lines adjacent in the column direction are connected together by a second common control line.

7. The flash memory array according to claim 5, wherein
The first control line, the word line and the second control line are formed of at least one of polysilicon, silicide, and a metal gate.

8. The flash memory array according to claim 6, wherein
The first common control line and the second common control line are formed of a metal layer.

9. The flash memory array according to claim 3 or 4, wherein
the middle bit line is formed of a first metal layer, and
the first bit line and the second bit line are formed of a second metal layer different from the first metal layer.

10. The flash memory array according to claim 9, wherein
the middle bit line includes a first portion extending in the column direction and a second portion extending in the row direction, and
the first bit line and the second bit line extend in the column direction.

11. A writing method of the flash memory array according to any one of claims 1 to 10, comprising:
performing a write operation on the first storage transistor of the first flash memory cell by applying a first writing voltage to the first bit line, applying a second writing voltage to the middle bit line and the second bit line, applying a third writing voltage to the first control line, applying a fourth writing voltage to the word line, and applying a fifth writing voltage to the second control line;
performing a write operation on the second storage transistor of the first flash memory cell by applying the second writing voltage to the first bit line, applying the first writing voltage to the middle bit line and the second bit line, applying the fifth writing voltage to the first control line, applying the fourth writing voltage to the word line, and applying the third writing voltage to the second control line;
performing a write operation on the first storage transistor of the second flash memory cell by applying the first writing voltage to the first bit line and the middle bit line, applying the second writing voltage to the second bit line, applying the third writing voltage to the first control line, applying the fourth writing voltage to the word line, and applying the fifth writing voltage to the second control line; and
performing a write operation on the second storage transistor of the second flash memory cell by applying the second writing voltage to the first bit line and the middle bit line, applying the first writing voltage to the second bit line, applying the fifth writing voltage to the first control line, applying the fourth writing voltage to the word line, and applying the third writing voltage to the second control line,
wherein the fourth writing voltage is equal to or lower than a first power voltage, the second writing voltage is equal to or higher than a second power voltage, the first writing voltage is higher than a preset voltage, and the third writing voltage is higher than the first writing voltage,
wherein the first power voltage is higher than the second power voltage,
wherein the preset voltage is predetermined based on a carrier barrier height at an interface between a substrate and gate dielectric stacks of the first storage transistor and the second storage transistor,
wherein the first writing voltage, the fourth writing voltage, and the fifth writing voltage are higher than the second writing voltage,
wherein the second writing voltage is connected to the second power voltage through a constant current load, and
wherein, during a writing operation of a flash memory cell, the first writing voltage, the second writing voltage, the third writing voltage, the fourth writing voltage, and the fifth writing voltage turn on all the first storage transistor, the second storage transistor, and the selection transistor of the flash memory cell.

12. The writing method according to claim 11, wherein
the first power voltage is in a range of 0.8 V to 5 V,
the second power voltage is a ground voltage,
the first writing voltage is in a range of 3 V to 6 V,
the third writing voltage is in a range of 4 V to 12 V, and
the fifth writing voltage is in a range of 3 V to 8 V

13. The writing method according to claim 11 or 12, wherein
during the write operation of the flash memory cell, a current flowing between the first electrode and the second electrode of the flash memory cell is controlled by controlling a current of the constant current load.

14. The writing method according to claim 11 or 12, wherein
during the write operation of the flash memory cell, the writing operation is performed on the first storage transistor or the second storage transistor of the flash memory cell by a channel hot carrier injection mechanism.

15. An erasing method of the flash memory array according to any one of claims 1 to 10, comprising a first erasing step of:
performing an erasing operation on the first storage transistors of the first flash memory cell and the second flash memory cell by applying a first erasing voltage to the first bit line, the middle bit line, and the second bit line, applying a second erasing voltage to the first control line, and applying a second power voltage to the word line and the second control line or floating the word line and the second control line; and
performing an erasing operation on the second storage transistors of the first flash memory cell and the second flash memory cell by applying the first erasing voltage to the first bit line, the middle bit line, and the second bit line, applying the second power voltage to the word line and the first control line or floating the word line and the first control line, and applying the second erasing voltage to the second control line,
wherein the first erasing voltage is higher than a preset voltage, and the second erasing voltage is equal to or lower than the second power voltage, and
wherein the preset voltage is predetermined based on a carrier barrier height at an interface between a substrate and gate dielectric stacks of the first storage transistor and the second storage transistor.

16. The erasing method according to claim 15, wherein
the second power voltage is a ground voltage,
the first erasing voltage is in a range of 3 V to 6 V, and
the second erasing voltage is in a range of -8 V to 0 V

17. The erasing method according to claim 15, further comprising a second erasing step of:
simultaneously performing an erasing operation on the first flash memory cell and the second flash memory cell by applying the first erasing voltage to the first bit line, the middle bit line, and the second bit line, applying the second erasing voltage to the first control line and the second control line, and applying the second power voltage to the word line or floating the word line.

18. The erasing method according to claim 15 or 17, wherein
during an erasing operation of a flash memory cell, the erasing operation is performed on the first storage transistor or the second storage transistor by a band-to-band tunneling hot carrier injection mechanism.

19. The erasing method according to claim 15, further comprising a third erasing step of:
simultaneously performing an erasing operation on the first flash memory cell and the second flash memory cell by applying a third erasing voltage to a substrate of the flash memory array, the first bit line, the middle bit line, and the second bit line, applying a fourth erasing voltage to the first control line and the second control line, and applying the second power voltage to the word line or floating the word line,
wherein the third erasing voltage is in a range of 0 V to 20 V, and the fourth erasing voltage is in a range of -10 V to 0 V

20. The erasing method according to claim 19, wherein
during an erasing operation of the flash memory cell, the erasing operation is performed on the first storage transistor or the second storage transistor by a Fowler-Nordheim tunneling mechanism.

21. The erasing method according to claim 19, further comprising:
firstly performing an erasing operation on the entire flash memory array by the third erasing step, and subsequently performing an erasing operation on a portion of flash memory cells in the flash memory array by the first erasing step or the second erasing step.

22. The erasing method according to claim 19, wherein
the third erasing voltage is the same as or different from the first erasing voltage, and
the fourth erasing voltage is the same as or different from the second erasing voltage.
